(19) Europäisches Patentamt
European Patent Office
Office européen des brevets

(11) EP 3 979 333 A1

(12) # EUROPEAN PATENT APPLICATION
published in accordance with Art. 153(4) EPC

(43) Date of publication:
**06.04.2022 Bulletin 2022/14**

(21) Application number: **20814093.9**

(22) Date of filing: **25.05.2020**

(51) International Patent Classification (IPC):
***H01L 31/0248*** *(2006.01)* ***G02B 5/20*** *(2006.01)*
***G02B 5/22*** *(2006.01)*

(52) Cooperative Patent Classification (CPC):
**G02B 5/20; G02B 5/22; H01L 31/0248**

(86) International application number:
**PCT/JP2020/020440**

(87) International publication number:
**WO 2020/241535 (03.12.2020 Gazette 2020/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.05.2019 JP 2019102164**

(71) Applicant: **FUJIFILM Corporation**
**Tokyo 106-8620 (JP)**

(72) Inventor: **MIYATA Tetsushi**
**Haibara-gun, Shizuoka 421-0396 (JP)**

(74) Representative: **HGF**
**HGF Limited**
**1 City Walk**
**Leeds LS11 9DX (GB)**

(54) **OPTICAL SENSOR AND SENSING DEVICE**

(57) Provided are an optical sensor and a sensing device, each including a photoelectric conversion element capable of acquiring light in a wavelength range including an infrared range, as an electric signal; and an optical member provided on a light incident side with respect to the photoelectric conversion element, in which the photoelectric conversion element includes a quantum dot having a maximum absorption wavelength $\lambda_{max}$ in an infrared range having a wavelength of 800 nm or longer, and has an infrared light receiving section that receives light in a wavelength range in the infrared range, and the optical member on an optical path on a light incident side with respect to the infrared light receiving section of the photoelectric conversion element has a maximum value of a light transmittance of 60% or more for light in the infrared range having a wavelength of 800 nm or longer and an average light transmittance of 10% or less for light in a wavelength range of 400 to 650 nm.

FIG. 1

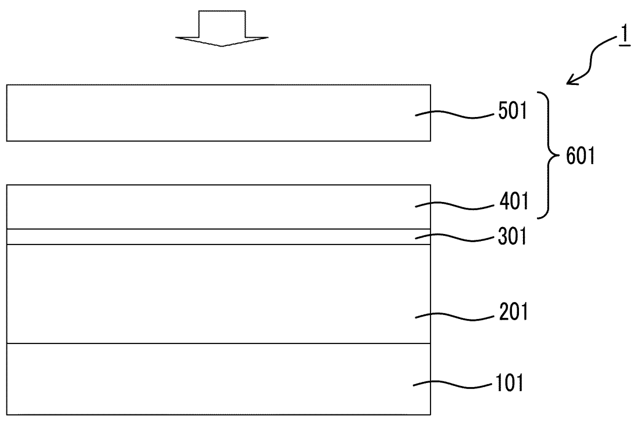




Printed by Jouve, 75001 PARIS (FR)

## Description

## BACKGROUND OF THE INVENTION

1. Field of the Invention

The present invention relates to an optical sensor and a sensing device. More specifically, the present invention relates to an optical sensor and a sensing device, each of which detects light including infrared light.

2. Description of the Related Art

A substance reduced to about several nm to ten and several nm exhibits physical properties different from those in a bulk state. Such a phenomenon is called a quantum size effect or the like, and a substance in which such an effect is exhibited is called a quantum dot. Changing a size of the quantum dot makes it possible to adjust a band gap thereof (light absorption wavelength or luminescence wavelength).

In recent years, research on the quantum dot has been underway. For example, the use of the quantum dot as a material for a photoelectric conversion element is being studied.

WO2017/150167A discloses an invention relating to a solid-state imaging element which includes a pixel array region in which pixels including a photoelectric conversion unit having any of a compound semiconductor, amorphous silicon, germanium, a quantum dot photoelectric conversion film, and an organic photoelectric conversion film are two-dimensionally arranged in a matrix, and which has voltage-applied pixels, which are pixels to which a constant voltage is always applied, on the outermost periphery of the pixel array region or outside an effective pixel region of the pixel array region.

## SUMMARY OF THE INVENTION

Infrared light (infrared ray) has a longer wavelength than visible light, so it is less likely to scatter and can also be used for distance measurement and three-dimensional measurement. In addition, infrared light is invisible to humans and animals, and therefore even in a case where a subject is illuminated with an infrared light source at night, the infrared light will not be noticed by the subject. For this reason, the infrared light can also be used for shooting nocturnal wild animals and for crime prevention without stimulating the other party. In this way, an optical sensor that senses infrared light can be developed in various applications, and various studies have been made on such an optical sensor.

An absorption peak or the like of the quantum dot can be easily adjusted by controlling a particle size thereof. However, the quantum dot has a relatively high photoelectric conversion ability even on a shorter wavelength side than a wavelength of a main absorption peak. For this reason, an optical sensor using the quantum dot in a photoelectric conversion element may detect light in a wide wavelength range. Therefore, in a case where an optical sensor using the quantum dot in the photoelectric conversion element is applied to an optical sensor that senses infrared light, there is room for improvement in reducing noise derived from sunlight.

Therefore, an object of the present invention is to provide a novel optical sensor and sensing device capable of detecting infrared light without noise.

The present invention provides the following.

<1> An optical sensor comprising:

> a photoelectric conversion element capable of acquiring light in a wavelength range including an infrared range, as an electric signal; and
> an optical member provided on a light incident side with respect to the photoelectric conversion element,
> in which the photoelectric conversion element includes a quantum dot having a maximum absorption wavelength $\lambda_{max}$ in an infrared range having a wavelength of 800 nm or longer, and has an infrared light receiving section that receives light in a wavelength range in the infrared range, and
> the optical member on an optical path on a light incident side with respect to the infrared light receiving section of the photoelectric conversion element is an infrared transmitting member having a maximum value of a light transmittance of 60% or more for light in the infrared range having a wavelength of 800 nm or longer and an average light transmittance of 10% or less for light in a wavelength range of 400 to 650 nm.

<2> The optical sensor according to <1>, in which the infrared transmitting member has a maximum value of a light transmittance of 60% or more for light in a range of the maximum absorption wavelength $\lambda_{max}$ of the quantum dot $\pm$ 50 nm and an average light transmittance of 10% or less for light in a wavelength range of 400 to 650 nm, and

the infrared light receiving section receives light of any wavelength in a range of the maximum absorption wavelength $\lambda_{max}$ of the quantum dot $\pm$ 50 nm.

<3> The optical sensor according to <1> or <2>, in which the infrared transmitting member has a wavelength having a light transmittance of 50% in a range of the maximum absorption wavelength $\lambda_{max}$ of the quantum dot - 200 nm or longer and the maximum absorption wavelength $\lambda_{max}$ of the quantum dot + 20 nm or shorter.

<4> The optical sensor according to any one of <1> to <3>, in which the infrared transmitting member satisfies Relational Expression (IR1):

$$(T^1/T^2) > 5.0 \qquad \text{(IR1)}$$

$T^1$ is a light transmittance of the infrared transmitting member for light having the maximum absorption wavelength $\lambda_{max}$ of the quantum dot, and

$T^2$ is a light transmittance of the infrared transmitting member for light having the maximum absorption wavelength $\lambda_{max}$ of the quantum dot $\times$ 0.8.

<5> The optical sensor according to any one of <1> to <4>, in which the infrared transmitting member includes a resin film containing a plurality of coloring materials.

<6> The optical sensor according to <5>, in which the resin film has a wavelength having a light transmittance of 50% in a range of the maximum absorption wavelength $\lambda_{max}$ of the quantum dot - 200 nm or longer and the maximum absorption wavelength $\lambda_{max}$ of the quantum dot + 20 nm or shorter.

<7> The optical sensor according to any one of <1> to <6>, in which the infrared transmitting member includes a dielectric multi-layer film.

<8> The optical sensor according to <7>, in which the dielectric multi-layer film has a plurality of transmission wavelength ranges having a maximum light transmittance of 90% or more.

<9> The optical sensor according to any one of <1> to <8>, in which the infrared transmitting member includes a microlens having a refractive index of 1.8 or more for light having the maximum absorption wavelength $\lambda_{max}$ of the quantum dot.

<10> The optical sensor according to any one of <1> to <9>, in which the photoelectric conversion element has another light receiving section that receives light having a wavelength different from a wavelength of the light received by the infrared light receiving section, and

the optical member has an optical filter including a plurality of pixels having different wavelengths of transmitted light.

<11> The optical sensor according to <10>, in which each pixel of the optical filter is compartmented by a partition wall.

<12> The optical sensor according to <10> or <11>, in which each of regions of the photoelectric conversion element that receives light transmitted through each pixel of the optical filter is compartmented by a partition wall or a groove.

<13> The optical sensor according to any one of <10> to <12>, in which the other light receiving section receives light on a shorter wavelength side than a wavelength of the light received by the infrared light receiving section.

<14> The optical sensor according to any one of <10> to <13>, in which pixels of the optical filter on an optical path on a light incident side of the other light receiving section have a wavelength having a light transmittance of 60% or more in a range of 400 nm or longer and the maximum absorption wavelength $\lambda_{max}$ of the quantum dot $\times$ 0.8 nm or shorter.

<15> The optical sensor according to any one of <1> to <14>, further comprising a light emitting device having an emission maximum in a range of the maximum absorption wavelength $\lambda_{max}$ of the quantum dot $\pm$ 50 nm.

<16> A sensing device comprising the optical sensor according to any one of <1> to <15>.

According to an aspect of the present invention, it is possible to provide a novel optical sensor capable of detecting infrared light without noise, a distance measurement device, and an imaging device.

## BRIEF DESCRIPTION OF THE DRAWINGS

Fig. 1 is a schematic diagram showing an embodiment of an optical sensor of the present invention.

Fig. 2 is a schematic diagram showing an embodiment of a photoelectric conversion element used in the optical sensor of the present invention.

Fig. 3 is a schematic diagram showing another embodiment of the optical sensor of the present invention.

Fig. 4 is a schematic diagram showing another embodiment of the optical sensor of the present invention.

Fig. 5 is a schematic diagram showing an embodiment of an optical filter.

## DESCRIPTION OF THE PREFERRED EMBODIMENTS

Hereinafter, the contents of the present invention will be described in detail.

In the present specification, the expression "to" is used to mean that the numerical values described before and after "to" are included as a lower limit value and an upper limit value, respectively.

In the present specification, the term "step" includes an independent step as well as a step that cannot be clearly distinguished from other steps but still achieves a desired effect of the step of interest.

<Optical sensor>

The optical sensor according to an embodiment of the present invention includes

a photoelectric conversion element capable of acquiring light in a wavelength range including an infrared range, as an electric signal; and
an optical member provided on a light incident side with respect to the photoelectric conversion element,
in which the photoelectric conversion element includes a quantum dot having a maximum absorption wavelength $\lambda_{max}$ in an infrared range having a wavelength of 800 nm or longer, and has an infrared light receiving section that receives light in a wavelength range in the infrared range, and
the optical member on an optical path on a light incident side with respect to the infrared light receiving section of the photoelectric conversion element is an infrared transmitting member having a maximum value of a light transmittance of 60% or more for light in the infrared range having a wavelength of 800 nm or longer and an average light transmittance of 10% or less for light in a wavelength range of 400 to 650 nm.

The optical sensor according to the embodiment of the present invention can receive infrared light of a target wavelength with less noise derived from sunlight at the infrared light receiving section, by using a photoelectric conversion element containing quantum dots having a maximum absorption wavelength $\lambda_{max}$ in the infrared range having a wavelength of 800 nm or longer, and providing the infrared transmitting member on the optical path on the light incident side with respect to the infrared light receiving section in the photoelectric conversion element. This makes it possible to improve the accuracy of sensing using infrared light. In addition, the optical sensor according to the embodiment of the present invention uses quantum dots in the photoelectric conversion element, and the absorption wavelength can be adjusted by adjusting the size or the like of the quantum dots. For example, the absorption wavelength can be shifted to the long wavelength side by increasing the size of the quantum dots, and the absorption wavelength can be shifted to the short wavelength side by reducing the size of the quantum dots. Therefore, it is possible to easily change or adjust the spectral design of the optical sensor, and it is easy to change the design according to the application and purpose of the optical sensor.

The infrared transmitting member may be configured of only a single member or layer, or may be configured of a plurality of members or layers arranged on an optical path. In addition, the optical member may be configured only of an infrared transmitting member having the above-mentioned spectral characteristics, or may have another light transmitting member having spectral characteristics different from the above-mentioned spectral characteristics on an optical path different from the optical path where the infrared light receiving section of the photoelectric conversion element is provided. Examples of the infrared transmitting member include a resin film containing a coloring material, a dielectric multi-layer film, and a combination thereof. For example, in a case of a resin film containing a coloring material, the spectral characteristics of the resin film can be adjusted by appropriately adjusting the type and content of the coloring material contained in the resin film. In addition, in a case of a dielectric multi-layer film, the spectral characteristics of the dielectric multi-layer film can be adjusted by adjusting the types, film thickness, number of lamination layers, and the like of a high refractive index material layer and a low refractive index material layer which will be described later.

The photoelectric conversion element may be a photoelectric conversion element capable of also acquiring light in a wavelength range in the visible range (preferably light in a wavelength range of 400 to 700 nm) as an electric signal, that is, a photoelectric conversion element having sensitivity to light in a wavelength range in the visible range. Even in a case where the photoelectric conversion element has sensitivity to light in a wavelength range in the visible range, providing the infrared transmitting member makes the infrared light receiving section possible to selectively receive infrared light of a target wavelength without noise derived from sunlight. In addition, in a case where the photoelectric conversion element also has sensitivity to light in a wavelength range in the visible range, appropriately adjusting the structure or the like of the optical member makes it possible to obtain an optical sensor capable of simultaneously detecting light in a wavelength range in the visible range and light in a wavelength range in the infrared range.

The photoelectric conversion element preferably has a layer containing quantum dots (hereinafter, also referred to as a quantum dot layer) as a photoelectric conversion layer. The photoelectric conversion element may include only the quantum dot layer as the photoelectric conversion layer, or may further include another photoelectric conversion

layer made of a material other than the quantum dot. Examples of the other photoelectric conversion layer include a silicon photodiode. For example, the photoelectric conversion element may be configured to have a combination of a silicon photodiode and a quantum dot layer such that light in a desired infrared range is photoelectrically converted by the quantum dot layer, and light in a wavelength range in the visible range (preferably light in a wavelength range of 400 to 700 nm) is photoelectrically converted by the silicon photodiode. In this case as well, providing the infrared transmitting member on the infrared light receiving section of the photoelectric conversion element makes it possible to selectively receive infrared light of a target wavelength without noise derived from sunlight.

The maximum absorption wavelength $\lambda_{max}$ of the quantum dots used in the photoelectric conversion element is present in a range of 800 nm or longer, preferably in a range of 800 to 4500 nm, more preferably in a range of 800 to 3500 nm, and still more preferably in a range of 800 to 2500 nm.

Examples of the material for the quantum dot include a semiconductor such as a III-V compound semiconductor, a II-VI compound semiconductor, a IV-VI compound semiconductor, or silicon, and carbon. Specific examples of the material for the quantum dot include CdS, CdSe, PbS, PbSe, and InAs. A ligand may be coordinated on the surface of the quantum dot. Examples of the ligand include a compound having a coordinating group such as an amino group, a carboxy group, a mercapto group, a phosphine group, or a phosphine oxide group. The ligand is preferably a polydentate ligand, more preferably a polydentate ligand in which at least one of the coordinating groups is selected from an amino group or a mercapto group, and still more preferably a bidentate or tridentate ligand in which at least one of the coordinating groups is selected from an amino group or a mercapto group. Specific examples of the ligand include hexylamine, decylamine, hexadecylamine, octadecylamine, oleylamine, myristylamine, laurylamine, oleic acid, mercaptopropionic acid, trioctylphosphine, and trioctylphosphine oxide. Above all, a ligand having a low molecular weight can be expected to have an effect of improving the photoelectric conversion ability by improving the conductivity.

In addition, the ligand of the quantum dot may be substituted during the film formation. In this case, both stability and conductivity can be achieved by using a ligand specialized for stability before film formation and using a ligand specialized for conductivity after film formation. Examples of the ligand specialized for stability include a ligand having a long-chain steric repulsive group such as octadecylamine, and examples of the ligand specialized for conductivity include a ligand having a low molecular weight such as mercaptopropionic acid.

The shape of the quantum dot is not particularly limited, and examples thereof include a spherical shape, a rod shape, and an elliptical spherical shape. In a case where the shape of the quantum dot is spherical, the average particle diameter of the quantum dot is preferably 0.1 to 100 nm, more preferably 0.5 to 50 nm, and still more preferably 1 to 25 nm. In the present specification, the average particle diameter of the quantum dot is a value measured by a dynamic light scattering method.

The table below shows the relationship between the average particle diameter and the maximum absorption wavelength of the quantum dot in a case where PbS is used as the material for the quantum dot. A quantum dot having a spherical shape was used. The maximum absorption wavelength of the quantum dot was measured as follows. That is, a quantum dot layer was formed by applying a toluene solution containing 4% by mass of the quantum dots (ligand: oleic acid) described in the table below onto a glass substrate by a spin coating method. The absorbance of this quantum dot layer in a wavelength range of 400 to 3300 nm was measured to determine the maximum absorption wavelength $\lambda_{max}$.

[Table 1]

| | Material | Average particle diameter (nm) | Maximum absorption wavelength $\lambda_{max}$ (nm) |
|---|---|---|---|
| QD-1 | PbS | 2.8 | 850 |
| QD-2 | PbS | 3.5 | 905 |
| QD-3 | PbS | 3.8 | 940 |
| QD-4 | PbS | 4.7 | 1120 |
| QD-5 | PbS | 5.8 | 1250 |
| QD-6 | PbS | 6.5 | 1380 |
| QD-7 | PbS | 7.8 | 1550 |

It is preferable that the infrared transmitting member has a maximum value of light transmittance of 60% or more for light in a range of the maximum absorption wavelength $\lambda_{max}$ of the quantum dot ± 50 nm (preferably in a range of the maximum absorption wavelength $\lambda_{max}$ of the quantum dot ± 40 nm, more preferably in a range of the maximum absorption wavelength $\lambda_{max}$ of the quantum dot ± 30 nm, still more preferably in a range of the maximum absorption wavelength $\lambda_{max}$ of the quantum dot ± 20 nm, and particularly preferably in a range of the maximum absorption wavelength $\lambda_{max}$ of the quantum dot ± 10 nm), and an average light transmittance of 10% or less for light in a wavelength range of

400 to 650 nm; and the infrared light receiving section receives light having any wavelength in a range of the maximum absorption wavelength $\lambda_{max}$ of the quantum dot ± 50 nm. According to this aspect, visible light noise in the infrared light receiving section can be suppressed, and therefore the accuracy of sensing using infrared light can be further improved. The maximum value of the light transmittance indicated by the infrared transmitting member for light in a range of the maximum absorption wavelength $\lambda_{max}$ of the quantum dot ± 50 nm is preferably 80% or more and more preferably 90% or more. In addition, the average light transmittance of the infrared transmitting member for light in a wavelength range of 400 to 650 nm is preferably 20% or less and more preferably 10% or less.

As an example of a preferred combination of the maximum absorption wavelength $\lambda_{max}$ of the quantum dot and the spectral characteristics of the infrared transmitting member, the aspects shown in (1) to (4) below can be mentioned.

(1): Aspect in which the maximum absorption wavelength $\lambda_{max}$ of the quantum dot used in the photoelectric conversion element is 800 nm or longer and shorter than 900 nm, and the spectral characteristics of the infrared transmitting member are such that the average light transmittance for light in a wavelength range of 400 to 650 nm is 10% or less (preferably 7.5% or less and more preferably 5% or less), and the maximum value of the light transmittance for light in the infrared range having a wavelength of 800 nm or longer is 60% or more (preferably 80% or more and more preferably 90% or more). In this aspect, the spectral characteristics of the light transmitting member are such that the maximum value of the light transmittance for light in a range of the maximum absorption wavelength $\lambda_{max}$ of the quantum dot ± 50 nm (preferably in a range of the maximum absorption wavelength $\lambda_{max}$ of the quantum dot ± 40 nm, more preferably in a range of the maximum absorption wavelength $\lambda_{max}$ of the quantum dot ± 30 nm, and still more preferably in a range of the maximum absorption wavelength $\lambda_{max}$ of the quantum dot ± 20 nm) is preferably 80% or more and more preferably 90% or more. In addition, the maximum value of the light transmittance for light in a wavelength range of 400 to 650 nm is preferably 20% or less, more preferably 15% or less, and still more preferably 10% or less.

(2): Aspect in which the maximum absorption wavelength $\lambda_{max}$ of the quantum dot used in the photoelectric conversion element is 900 nm or longer and shorter than 1000 nm, and the spectral characteristics of the infrared transmitting member are such that the average light transmittance for light in a wavelength range of 400 to 750 nm is 10% or less (preferably 7.5% or less and more preferably 5% or less), and the maximum value of the light transmittance for light in the infrared range having a wavelength of 900 nm or longer is 60% or more (preferably 80% or more and more preferably 90% or more). In this aspect, the spectral characteristics of the light transmitting member are such that the maximum value of the light transmittance for light in a range of the maximum absorption wavelength $\lambda_{max}$ of the quantum dot ± 50 nm (preferably in a range of the maximum absorption wavelength $\lambda_{max}$ of the quantum dot ± 40 nm, more preferably in a range of the maximum absorption wavelength $\lambda_{max}$ of the quantum dot ± 30 nm, and still more preferably in a range of the maximum absorption wavelength $\lambda_{max}$ of the quantum dot ± 20 nm) is preferably 80% or more and more preferably 90% or more. In addition, the maximum value of the light transmittance for light in a wavelength range of 400 to 750 nm is preferably 20% or less, more preferably 15% or less, and still more preferably 10% or less.

(3): Aspect in which the maximum absorption wavelength $\lambda_{max}$ of the quantum dot used in the photoelectric conversion element is 1000 nm or longer and shorter than 1100 nm, and the spectral characteristics of the infrared transmitting member are such that the average light transmittance for light in a wavelength range of 400 to 850 nm is 10% or less (preferably 7.5% or less and more preferably 5% or less), and the maximum value of the light transmittance for light in the infrared range having a wavelength of 1000 nm or longer is 60% or more (preferably 80% or more and more preferably 90% or more). In this aspect, the spectral characteristics of the light transmitting member are such that the maximum value of the light transmittance for light in a range of the maximum absorption wavelength $\lambda_{max}$ of the quantum dot ± 50 nm (preferably in a range of the maximum absorption wavelength $\lambda_{max}$ of the quantum dot ± 40 nm, more preferably in a range of the maximum absorption wavelength $\lambda_{max}$ of the quantum dot ± 30 nm, and still more preferably in a range of the maximum absorption wavelength $\lambda_{max}$ of the quantum dot ± 20 nm) is preferably 80% or more and more preferably 90% or more. In addition, the maximum value of the light transmittance for light in a wavelength range of 400 to 850 nm is preferably 20% or less, more preferably 15% or less, and still more preferably 10% or less.

(4): Aspect in which the maximum absorption wavelength $\lambda_{max}$ of the quantum dot used in the photoelectric conversion element is 1100 nm or longer, and the spectral characteristics of the infrared transmitting member are such that the average light transmittance for light in a wavelength range of 400 to 950 nm is 10% or less (preferably 7.5% or less and more preferably 5% or less), and the maximum value of the light transmittance for light in the infrared range having a wavelength of 1100 nm or longer is 60% or more (preferably 80% or more and more preferably 90% or more). In this aspect, the spectral characteristics of the light transmitting member are such that the maximum value of the light transmittance for light in a range of the maximum absorption wavelength $\lambda_{max}$ of the quantum dot ± 50 nm (preferably in a range of the maximum absorption wavelength $\lambda_{max}$ of the quantum dot ± 40 nm, more preferably

in a range of the maximum absorption wavelength $\lambda_{max}$ of the quantum dot ± 30 nm, and still more preferably in a range of the maximum absorption wavelength $\lambda_{max}$ of the quantum dot ± 20 nm) is preferably 80% or more and more preferably 90% or more. In addition, the maximum value of the light transmittance for light in a wavelength range of 400 to 950 nm is preferably 20% or less, more preferably 15% or less, and still more preferably 10% or less.

The infrared transmitting member preferably has a wavelength having a light transmittance of 50% in a range of the maximum absorption wavelength $\lambda_{max}$ of the quantum dot - 200 nm or longer and the maximum absorption wavelength $\lambda_{max}$ of the quantum dot or shorter (preferably in a range of $\lambda_{max}$ - 175 to $\lambda_{max}$ + 10 nm, and more preferably in a range of $\lambda_{max}$ - 150 to $\lambda_{max}$ + 20 nm). Since such an infrared transmitting member has high transmittance of light in the vicinity of the maximum absorption wavelength $\lambda_{max}$ of the quantum dot, the amount of light in the vicinity of the maximum absorption wavelength $\lambda_{max}$ of the quantum dot incident on the infrared light receiving section of the quantum dot can be increased, and therefore the accuracy of sensing using infrared light can be further improved.

The infrared transmitting member preferably satisfies Relational Expression (IR1). Since such an infrared transmitting member can selectively transmit light in the vicinity of the maximum absorption wavelength $\lambda_{max}$ of the quantum dot, it is possible to increase a signal-to-noise ratio (SN ratio) of light in the vicinity of the maximum absorption wavelength $\lambda_{max}$ of the quantum dot in the infrared light receiving section. The value of $(T^1/T^2)$ in Relational Expression (IR1) is preferably 5 or more, more preferably 7.5 or more, and still more preferably 10 or more.

$$(T^1/T^2) > 5.0 \qquad \text{(IR1)}$$

$T^1$ is a light transmittance of the infrared transmitting member for light having the maximum absorption wavelength $\lambda_{max}$ of the quantum dot, and

$T^2$ is a light transmittance of the infrared transmitting member for light having the maximum absorption wavelength $\lambda_{max}$ of the quantum dot × 0.8.

The infrared transmitting member may include a resin film containing a plurality of coloring materials. According to this aspect, it is easy to adjust the spectral characteristics of the infrared transmitting member to a desired range. The resin film is preferably an infrared transmitting filter. Examples of the coloring material contained in the resin film include chromatic coloring materials such as a red coloring material, a green coloring material, a blue coloring material, a yellow coloring material, a violet coloring material, and an orange coloring material.

Examples of pigments used as the chromatic coloring material include pigments shown below.

Color Index (C.I.) Pigment Yellow 1, 2, 3, 4, 5, 6, 10, 11, 12, 13, 14, 15, 16, 17, 18, 20, 24, 31, 32, 34, 35, 35:1, 36, 36:1, 37, 37:1, 40, 42, 43, 53, 55, 60, 61, 62, 63, 65, 73, 74, 77, 81, 83, 86, 93, 94, 95, 97, 98, 100, 101, 104, 106, 108, 109, 110, 113, 114, 115, 116, 117, 118, 119, 120, 123, 125, 126, 127, 128, 129, 137, 138, 139, 147, 148, 150, 151, 152, 153, 154, 155, 156, 161, 162, 164, 166, 167, 168, 169, 170, 171, 172, 173, 174, 175, 176, 177, 179, 180, 181, 182, 185, 187, 188, 193, 194, 199, 213, 214, 215, 228, 231, 232 (methine-based), 233 (quinoline-based), and the like (all of which are yellow pigments),

C.I. Pigment Orange 2, 5, 13, 16, 17:1, 31, 34, 36, 38, 43, 46, 48, 49, 51, 52, 55, 59, 60, 61, 62, 64, 71, 73, and the like (all of which are orange pigments),

C.I. Pigment Red 1, 2, 3, 4, 5, 6, 7, 9, 10, 14, 17, 22, 23, 31, 38, 41, 48:1, 48:2, 48:3, 48:4, 49, 49:1, 49:2, 52:1, 52:2, 53:1, 57:1, 60:1, 63:1, 66, 67, 81:1, 81:2, 81:3, 83, 88, 90, 105, 112, 119, 122, 123, 144, 146, 149, 150, 155, 166, 168, 169, 170, 171, 172, 175, 176, 177, 178, 179, 184, 185, 187, 188, 190, 200, 202, 206, 207, 208, 209, 210, 216, 220, 224, 226, 242, 246, 254, 255, 264, 270, 272, 279, 294 (xanthene-based, Organo Ultramarine, Blush Red), 295 (monoazo-based), 296 (diazo-based), and the like (all of which are red pigments),

C.I. Pigment Green 7, 10, 36, 37, 58, 59, 62, 63, and the like (all of which are green pigments),

C.I. Pigment Violet 1, 19, 23, 27, 32, 37, 42, 60 (triarylmethane-based), 61 (xanthene-based), and the like (all of which are violet pigments), and

C.I. Pigment Blue 1, 2, 15, 15:1, 15:2, 15:3, 15:4, 15:6, 16, 22, 29, 60, 64, 66, 79, 80, 87 (monoazo-based), 88 (methine-based), and the like (all of which are blue pigments).

In addition, a halogenated zinc phthalocyanine pigment having an average of 10 to 14 halogen atoms, an average of 8 to 12 bromine atoms, and an average of 2 to 5 chlorine atoms in one molecule can also be used as the green coloring material. Specific examples of the green coloring material include compounds described in WO2015/118720A. In addition, compounds described in Chinese Patent Application No. 1069009027, phthalocyanine compounds having a phosphate ester as a ligand described in WO2012/102395A, phthalocyanine compounds described in JP2019-008014A, and phthalocyanine compounds described in JP2018-180023A can also be used as the green coloring material.

In addition, an aluminum phthalocyanine compound having a phosphorus atom can also be used as the blue coloring material. Specific examples of the blue coloring material include compounds described in paragraphs [0022] to

[0030] of JP2012-247591A and paragraph [0047] of JP2011-157478A.

In addition, compounds described in JP2017-201003A, compounds described in JP2017-197719A, compounds described in paragraphs [0011] to [0062] and [0137] to [0276] of JP2017-171912A, compounds described in paragraphs [0010] to [0062] and [0138] to

**[0039]** of JP2017-171913A, compounds described in paragraphs [0011] to [0062] and [0139] to [0190] of JP2017-171914A, compounds described in paragraphs [0010] to [0065] and [0142] to [0222] of JP2017-171915A, quinophthalone compounds described in paragraphs [0011] to [0034] of JP2013-054339A, quinophthalone compounds described in paragraphs [0013] to [0058] of JP2014-026228A, isoindoline compounds described in JP2018-062644A, quinophthalone compounds described in JP2018-203798A, quinophthalone compounds described in JP2018-062578A, quinophthalone compounds described in JP6432077B, quinophthalone compounds described in JP6432076B, quinophthalone compounds described in JP2018-155881A, quinophthalone compounds described in JP2018-111757A, quinophthalone compounds described in JP2018-040835A, quinophthalone compounds described in JP2017-197640A, quinophthalone compounds described in JP2016-145282A, quinophthalone compounds described in JP2014-085565A, quinophthalone compounds described in JP2014-021139A, quinophthalone compounds described in JP2013-209614A, quinophthalone compounds described in JP2013-209435A, quinophthalone compounds described in JP2013-181015A, quinophthalone compounds described in JP2013-061622A, quinophthalone compounds described in JP2013-054339A, quinophthalone compounds described in JP2013-032486A, quinophthalone compounds described in JP2012-226110A, quinophthalone compounds described in JP2008-074987A, quinophthalone compounds described in JP2008-081565A, quinophthalone compounds described in JP2008-074986A, quinophthalone compounds described in JP2008-074985A, quinophthalone compounds described in JP2008-050420A, quinophthalone compounds described in JP2008-031281A, quinophthalone compounds described in JP1973-032765B (JP-S48-032765B), quinophthalone compounds described in JP2019-008014A, compounds represented by Formula (QP1), and compounds represented by Formula (QP2) can also be used as the yellow coloring material.

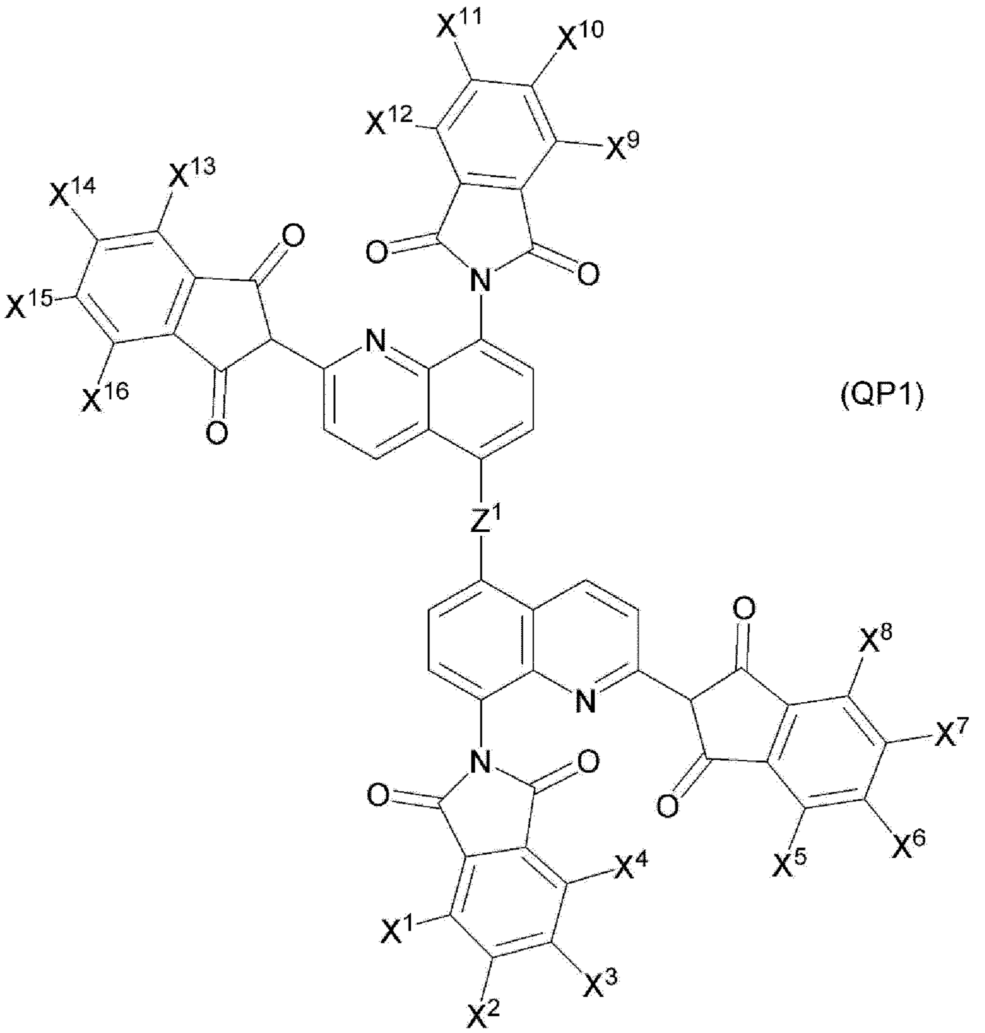

(QP1)

In Formula (QP1), $X^1$ to $X^{16}$ each independently represent a hydrogen atom or a halogen atom, and $Z^1$ represents an alkylene group having 1 to 3 carbon atoms. Specific examples of the compound represented by Formula (QP1) include compounds described in paragraph [0016] of JP6443711B.

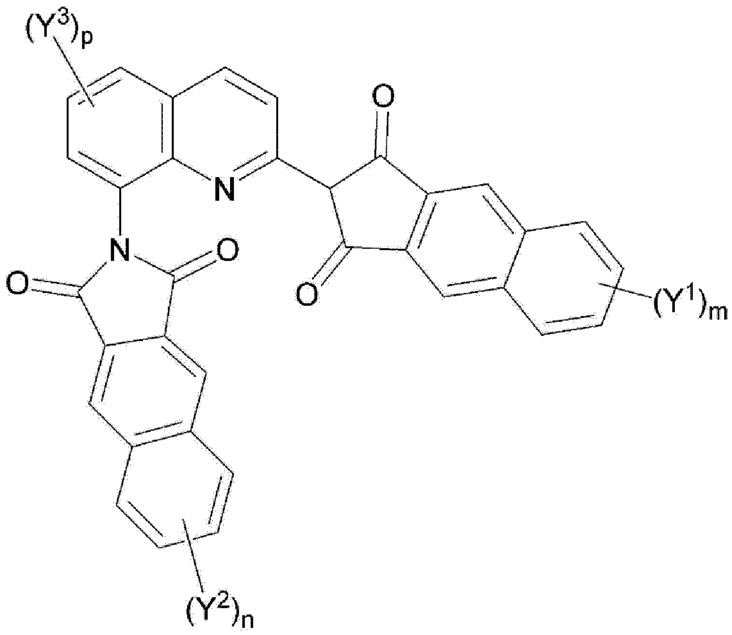

(QP2)

In Formula (QP2), $Y^1$ to $Y^3$ each independently represent a halogen atom. n and m each represent an integer of 0 to 6, and p represents an integer of 0 to 5. (n + m) is 1 or more. Specific examples of the compound represented by Formula (QP2) include compounds described in paragraphs [0047] and [0048] of JP6432077B.

Diketopyrrolo pyrrole compounds in which at least one bromine atom is substituted in a structure thereof described in JP2017-201384A, diketopyrrolo pyrrole compounds described in paragraphs [0016] to [0022] of JP6248838B, diketopyrrolo pyrrole compounds described in WO2012/102399A, diketopyrrolo pyrrole compounds described in WO2012/117965A, naphthol azo compounds described in JP2012-229344A, and the like can also be used as the red coloring material. In addition, a compound having a structure in which an aromatic ring group into which a group having an oxygen atom, a sulfur atom, or a nitrogen atom bonded to the aromatic ring is introduced is bonded to a diketopyrrolo pyrrole skeleton can also be used as the red pigment.

A dye can also be used as the coloring material. The dye is not particularly limited, and a known dye can be used. Examples thereof include dyes such as a pyrazole azo-based dye, an anilino azo-based dye, a triarylmethane-based dye, an anthraquinone-based dye, an anthrapyridone-based dye, a benzylidene-based dye, an oxonol-based dye, a pyrazolotriazole azo-based dye, a pyridone azo-based dye, a cyanine-based dye, a phenothiazine-based dye, a pyrrolopyrazole azomethine-based dye, a xanthene-based dye, a phthalocyanine-based dye, a benzopyran-based dye, an indigo-based dye, and a pyrromethene-based dye. In addition, thiazole compounds described in JP2012-158649A, azo compounds described in JP2011-184493A, and azo compound described in JP2011-145540A can also be preferably used. In addition, quinophthalone compounds described in paragraphs [0011] to [0034] of JP2013-054339A, quinophthalone compounds described in paragraphs [0013] to [0058] of JP2014-026228A, and the like can also be used as the yellow dye.

The coloring material contained in the resin film preferably forms black by combination of two or more types of chromatic coloring materials. Examples of the combination of the chromatic coloring materials in a case of forming black by the combination of two or more types of chromatic coloring materials include the following aspects (C1) to (C7).

(C1) Aspect containing a red coloring material and a blue coloring material.

(C2) Aspect containing a red coloring material, a blue coloring material, and a yellow coloring material.

(C3) Aspect containing a red coloring material, a blue coloring material, a yellow coloring material, and a violet coloring material.

(C4) Aspect containing a red coloring material, a blue coloring material, a yellow coloring material, a violet coloring material, and a green coloring material.

(C5) Aspect containing a red coloring material, a blue coloring material, a yellow coloring material, and a green coloring material.

(C6) Aspect containing a red coloring material, a blue coloring material, and a green coloring material.

(C7) Aspect containing a yellow coloring material and a violet coloring material.

In the aspect (C1), the mass ratio of the red coloring material and the blue coloring material is red coloring material:blue coloring material of preferably 20 to 80:20 to 80, more preferably 20 to 60:40 to 80, and still more preferably 20 to 50:50 to 80.

In the aspect (C2), the mass ratio of the red coloring material, the blue coloring material, and the yellow coloring material is red coloring material:blue coloring material:yellow coloring material of preferably 10 to 80:20 to 80:10 to 40, more preferably 10 to 60:30 to 80:10 to 30, and still more preferably 10 to 40:40 to 80:10 to 20.

In the aspect (C3), the mass ratio of the red coloring material, the blue coloring material, the yellow coloring material, and the violet coloring material is red coloring material:blue coloring material:yellow coloring material:violet coloring material of preferably 10 to 80:20 to 80:5 to 40:5 to 40, more preferably 10 to 60:25 to 80:5 to 30:5 to 30, and still more preferably 10 to 40:25 to 50:10 to 30:10 to 30.

In the aspect (C4), the mass ratio of the red coloring material, the blue coloring material, the yellow coloring material, the violet coloring material, and the green coloring material is red coloring material:blue coloring material:yellow coloring material:violet coloring material:green coloring material of preferably 10 to 80:20 to 80:5 to 40:5 to 40:5 to 40, more preferably 10 to 60:30 to 80:5 to 30:5 to 30:5 to 30, and still more preferably 10 to 40:40 to 80:5 to 20:5 to 20:5 to 20.

In the aspect (C5), the mass ratio of the red coloring material, the blue coloring material, the yellow coloring material, and the green coloring material is red coloring material:blue coloring material:yellow coloring material:green coloring material of preferably 10 to 80:20 to 80:5 to 40:5 to 40, more preferably 10 to 60:30 to 80:5 to 30:5 to 30, and still more preferably 10 to 40:40 to 80:5 to 20:5 to 20.

In the aspect (C6), the mass ratio of the red coloring material, the blue coloring material, and the green coloring material is red coloring material:blue coloring material:green coloring material of preferably 10 to 80:20 to 80:10 to 40, more preferably 10 to 60:30 to 80:10 to 30, and still more preferably 10 to 40:40 to 80:10 to 20.

In the aspect (C7), the mass ratio of the yellow coloring material and the violet coloring material is yellow coloring material:violet coloring material of preferably 10 to 50:40 to 80, more preferably 20 to 40:50 to 70, and still more preferably 30 to 40:60 to 70.

The coloring material contained in the resin film may be a pigment or a dye. The resin film may contain a pigment and a dye. The coloring material is preferably a pigment from the viewpoint of excellent long-term reliability. In addition, the average particle diameter of the pigment contained in the resin film is preferably 1 to 150 nm. The lower limit of the average particle diameter of the pigment is preferably 1 nm or more and more preferably 5 nm or more. The upper limit of the average particle diameter of the pigment is preferably 150 nm or less, more preferably 100 nm or less, and still more preferably 50 nm or less. In a case where the average particle diameter of the pigment is in the above range, the transmittance of the target wavelength is favorable. The average particle diameter of the pigment in the resin film is a value of volume cumulative particle diameter D50 obtained by a dynamic light scattering method.

The resin film may further contain an infrared absorber. The wavelength of the transmitted light can be shifted to the longer wavelength side by including the infrared absorber in the resin film. Examples of the infrared absorber include a pyrrolo pyrrole compound, a cyanine compound, a squarylium compound, a phthalocyanine compound, a naphthalocyanine compound, a quaterrylene compound, a merocyanine compound, a croconium compound, an oxonol compound, an iminium compound, a dithiol compound, a triarylmethane compound, a pyrromethene compound, an azomethine compound, an anthraquinone compound, a dibenzofuranone compound, a dithiolene metal complex, a metal oxide, and a metal boride. Examples of the pyrrolo pyrrole compound include compounds described in paragraphs [0016] to [0058] of JP2009-263614A, compounds described in paragraphs [0037] to [0052] of JP2011-068731A, and compounds described in paragraphs [0010] to [0033] of WO2015/166873A. Examples of the squarylium compound include compounds described in paragraphs [0044] to [0049] of JP2011-208101A, compounds described in paragraphs [0060] and [0061] of JP6065169B, compounds described in paragraph [0040] of WO2016/181987A, compounds described in JP2015-176046A, compounds described in paragraph [0072] of WO2016/190162A, compounds described in paragraphs [0196] to [0228] of JP2016-074649A, compounds described in paragraph [0124] of JP2017-067963A, compounds described in WO2017/135359A, compounds described in JP2017-114956A, compounds described in JP6197940B, and compounds described in WO2016/120166A. Examples of the cyanine compound include compounds described in paragraphs [0044] and [0045] of JP2009-108267A, compounds described in paragraphs [0026] to [0030] of JP2002-194040A, compounds described in JP2015-172004A, compounds described in JP2015-172102A, compounds described in JP2008-088426A, compounds described in paragraph [0090] of WO2016/190162A, and compounds described in JP2017-031394A. Examples of the croconium compound include compounds described in JP2017-082029A. Examples of the iminium compound include compounds described in JP2008-528706A, compounds described in JP2012-012399A, compounds described in JP2007-092060A, and compounds described in paragraphs [0048] to [0063] of WO2018/043564A. Examples of the phthalocyanine compound include compounds described in paragraph [0093] of JP2012-077153A, oxytitaniumphthalocyanines described in JP2006-343631A, compounds described in paragraphs [0013] to [0029] of JP2013-195480A, and vanadium phthalocyanine compounds described in JP6081771B. Examples of the naphthalocyanine compound include compounds described in paragraph [0093] of JP2012-077153A. Examples

of the dithiolene metal complex include compounds described in JP5733804B. Examples of the metal oxide include indium tin oxide, antimony tin oxide, zinc oxide, Al-doped zinc oxide, fluorine-doped tin dioxide, niobium-doped titanium dioxide, and tungsten oxide. For the details of tungsten oxide, reference can be made to paragraph [0080] of JP2016-006476A, the contents of which are incorporated herein by reference. Examples of the metal boride include lanthanum boride. Examples of commercially available lanthanum boride include $LaB_6$-F (manufactured by Japan New Metals Co., Ltd.). In addition, compounds described in WO2017/119394A can also be used as the metal boride. Examples of commercially available indium tin oxide include F-ITO (manufactured by DOWA Hi-Tech Co., Ltd.).

Squarylium compounds described in JP2017-197437A, squarylium compounds described in JP2017-025311A, squarylium compounds described in WO2016/154782A, squarylium compounds described in JP5884953B, squarylium compounds described in JP6036689B, squarylium compounds described in JP5810604B, squarylium compounds described in paragraphs [0090] to [0107] of WO2017/213047A, pyrrole ring-containing compounds described in paragraphs [0019] to [0075] of JP2018-054760A, pyrrole ring-containing compounds described in paragraphs [0078] to [0082] of JP2018-040955A, pyrrole ring-containing compounds described in paragraphs [0043] to [0069] of JP2018-002773A, squarylium compounds having an aromatic ring at the amide $\alpha$-position described in paragraphs [0024] to [0086] of JP2018-041047A, amide-linked squarylium compounds described in JP2017-179131A, compounds having a pyrrole bis-type squarylium skeleton or croconium skeleton described in JP2017-141215A, dihydrocarbazole bis-type squarylium compounds described in JP2017-082029A, asymmetric type compounds described in paragraphs [0027] to [0114] of JP2017-068120A, pyrrole ring-containing compounds (carbazole type) described in JP2017-067963A, phthalocyanine compounds described in JP6251530B, and the like can also be used as the infrared absorber.

The maximum value of the light transmittance indicated by the resin film for light in the infrared range having a wavelength of 800 nm or longer is preferably 60% or more, more preferably 80% or more, and still more preferably 90% or more. In addition, it is preferable that the resin film has high transmittance of light having a target wavelength to be received by the infrared light receiving section of the photoelectric conversion element, among the light in a wavelength range in the infrared range having a wavelength of 800 nm or longer. The light transmittance for light having the above-mentioned wavelength is preferably 60% or more, more preferably 70% or more, and still more preferably 80% or more.

The resin film preferably has a wavelength having a light transmittance of 50% in a range of the maximum absorption wavelength $\lambda_{max}$ of the quantum dot - 200 nm or longer and the maximum absorption wavelength $\lambda_{max}$ of the quantum dot or shorter (preferably in a range of $\lambda_{max}$ - 175 to $\lambda_{max}$ + 10 nm, and more preferably in a range of $\lambda_{max}$ - 150 to $\lambda_{max}$ + 20 nm). According to this aspect, the signal-to-noise ratio (SN ratio) or the like in the infrared light receiving section can be increased.

The average light transmittance indicated by the resin film for light in a wavelength range of 400 to 650 nm is preferably low, more preferably 10% or less, and still more preferably 5% or less.

The infrared transmitting member may include a dielectric multi-layer film. According to this aspect, light shielding and transmission can be carried out more steeply. Above all, it is preferable that the infrared transmitting member includes a dielectric multi-layer film and the above-mentioned resin film from the viewpoint that it is easy to adjust to more excellent spectral characteristics. The resin film and the dielectric multi-layer film may be in contact with each other, or the resin film and the dielectric multi-layer film may be separated from each other. In addition, the dielectric multi-layer film is preferably provided on the light incident side of the resin film from the viewpoint of reducing the angle dependence.

Examples of the dielectric multi-layer film include a dielectric multi-layer in which a plurality of layers of a dielectric thin film having a high refractive index (high refractive index material layer) and a dielectric thin film having a low refractive index (low refractive index material layer) are alternately laminated. The number of laminated dielectric thin films in the dielectric multi-layer film is not particularly limited, and is preferably 2 to 100 layers, more preferably 4 to 60 layers, and still more preferably 6 to 40 layers. The material used for forming the high refractive index material layer is preferably a material having a refractive index of 1.7 to 2.5. Specific examples of such a material include $Sb_2O_3$, $Sb_2S_3$, $Bi_2O_3$, $CeO_2$, $CeF_3$, $HfO_2$, $La_2O_3$, $Nd_2O_3$, $Pr_6O_{11}$, $Sc_2O_3$, SiO, $Ta_2O_5$, $TiO_2$, TlCl, $Y_2O_3$, ZnSe, ZnS, and $ZrO_2$. The material used for forming the low refractive index material layer is preferably a material having a refractive index of 1.2 to 1.6. Specific examples of such a material include $Al_2O_3$, $BiF_3$, $CaF_2$, $LaF_3$, $PbCl_2$, $PbF_2$, LiF, $MgF_2$, MgO, $NdF_3$, $SiO_2$, $Si_2O_3$, NaF, $ThO_2$, $ThF_4$, and $Na_3AlF_6$. The method for forming the dielectric multi-layer film is not particularly limited, and examples thereof include a vacuum vapor deposition method such as ion plating or ion beam, a physical vapor deposition method (PVD method) such as sputtering, and a chemical vapor deposition method (CVD method). The thickness of each of the high refractive index material layer and the low refractive index material layer is preferably 0.1 $\lambda$ to 0.5 $\lambda$ of a wavelength $\lambda$ (nm) of the light to be blocked.

The dielectric multi-layer film preferably has a transmission wavelength range in the infrared range having a wavelength of 800 nm or longer. In addition, it is preferable that the wavelength range of the transmission wavelength range includes a target wavelength to be received by the infrared light receiving section. In addition, the maximum light transmittance in the transmission wavelength range is preferably 70% or more, more preferably 80% or more, and still more preferably 90% or more. In addition, the maximum light transmittance in the light-shielding wavelength range is preferably 20% or less, more preferably 10% or less, and still more preferably 5% or less. In addition, the average light

transmittance in the transmission wavelength range is preferably 60% or more, more preferably 70% or more, and still more preferably 80% or more. In addition, in a case where the wavelength showing the maximum light transmittance is defined as a central wavelength $\lambda_{tl}$, the wavelength range of the transmission wavelength range is preferably the central wavelength $\lambda_{tl} \pm 100$ nm, more preferably the central wavelength $\lambda_{tl} \pm 75$ nm, and still more preferably the central wavelength $\lambda_{tl} \pm 50$ nm.

The dielectric multi-layer film may have only one transmission wavelength range (preferably, a transmission wavelength range having a maximum light transmittance of 90% or more), or may have a plurality of transmission wavelength ranges. In a case where a dielectric multi-layer film having a plurality of transmission wavelength ranges is used, light in different wavelength ranges can be incident on the photoelectric conversion element, and an optical sensor capable of simultaneously detecting light of different wavelengths can be obtained.

The infrared transmitting member may include a microlens having a refractive index of 1.8 or more for light having the maximum absorption wavelength $\lambda_{max}$ of the quantum dot. According to this aspect, the infrared light focusing rate can be increased, and the accuracy of sensing using infrared light can be further improved. Examples of the material used for forming a microlens having a high refractive index for light having the maximum absorption wavelength $\lambda_{max}$ of the quantum dot include a resin film using a coloring material having an absorption maximum at a wavelength shorter than $\lambda_{max}$ and no absorption at $\lambda_{max}$.

The photoelectric conversion element may have another light receiving section that receives light having a wavelength different from the wavelength of light received by the infrared light receiving section, and the optical member may have an optical filter including a plurality of pixels having different wavelengths of transmitted light. The pixels of the optical filter on the optical path on the light incident side of the other light receiving section preferably have a wavelength having a light transmittance of 60% or more (preferably 70 % or more and more preferably 80% or more) in a range of 400 nm or longer and the maximum absorption wavelength $\lambda_{max}$ of the quantum dot $\times$ 0.8 nm. Examples of such a pixel include colored pixels such as a red pixel, a blue pixel, a green pixel, a yellow pixel, a cyan pixel, and a magenta pixel. The other light receiving section is preferably a light receiving section that receives light on a shorter wavelength side than the wavelength of the light received by the infrared light receiving section. In addition, the other light receiving section is also preferably a light receiving section that receives light on a shorter wavelength side than the maximum absorption wavelength $\lambda_{max}$ of the quantum dot. Among the pixels included in the optical filter, the pixels existing on the optical path on the light incident side with respect to the infrared light receiving section are a part of the members constituting the infrared transmitting member.

Each pixel of the optical filter may be compartmented by a partition wall. In addition, each of regions (light receiving sections) of the photoelectric conversion element that receives the light transmitted through each pixel of the optical filter may be compartmented by a partition wall or a groove. According to these aspects, external quantum efficiency and the like can be increased.

The material for the partition wall is not particularly limited. Examples thereof include an organic material such as a siloxane resin or a fluororesin, and an inorganic particle such as a silica particle. In addition, the partition wall may be made of a metal such as tungsten or aluminum. In addition, the partition wall may be a laminate of a metal and a black matrix. In a case of a laminate, the lamination order of the metal and the black matrix is not particularly limited.

The optical sensor may further have a light emitting device having an emission maximum in a range of the maximum absorption wavelength $\lambda_{max}$ of the quantum dot $\pm$ 50 nm. Examples of such a light emitting device include a light emitting diode and a laser.

Embodiments of the optical sensor according to the embodiment of the present invention will be described below with reference to the accompanying drawings. The arrow in a figure represents an incidence ray on a photoelectric conversion element.

(First embodiment)

In an optical sensor 1 shown in Fig. 1, a photoelectric conversion element 201 is provided on a support 101. The light-receiving surface of the photoelectric conversion element 201 forms a light receiving section. In the optical sensor 1 shown in Fig. 1, the entire light-receiving surface of the photoelectric conversion element 201 forms an infrared light receiving section.

The support 101 is not particularly limited. The support 101 may be, for example, a glass substrate, a ceramics substrate, a resin substrate, or a semiconductor substrate. Examples of the semiconductor substrate include a silicon substrate, a silicon on insulator (SOI) substrate, and a substrate in which a silicon epitaxial growth layer is formed on a silicon layer of an SOI substrate. In addition, a transfer gate for reading out the signal charges photoelectrically converted by the photoelectric conversion element 201 may be formed on the support 101. In addition, a wiring part may be formed on the support 101.

Examples of the type of the photoelectric conversion element 201 include a photoconductor type photoelectric conversion element and a photodiode type photoelectric conversion element.

The photoelectric conversion element 201 will be described in more detail with reference to Fig. 2. Fig. 2 is a schematic diagram showing an example of the photoelectric conversion element 201. The photoelectric conversion element 201 shown in Fig. 2 includes a lower electrode 252, an upper electrode 253 facing the lower electrode 252, and a photoelectric conversion layer 251 provided between the lower electrode 252 and the upper electrode 253. The photoelectric conversion element 201 shown in Fig. 2 is used by allowing light to be incident from above the upper electrode 253. Although not shown, a charge transport layer may be provided between the photoelectric conversion layer 251 and the lower electrode 252 and/or between the photoelectric conversion layer 251 and the upper electrode 253. Hereinafter, the upper electrode and the lower electrode are collectively referred to as an electrode. By providing the charge transport layer between these electrodes and the photoelectric conversion layer 251, the charge separation efficiency in the photoelectric conversion layer 251 can be improved, and the light receiving sensitivity of infrared light or the like can be improved. Examples of the charge transport layer include a hole transport layer and an electron transport layer. Examples of the material for the hole transport layer include poly(3,4-ethylenedioxythiophene):poly(4-styrenesulfonate) (PEDOT:PSS) and MoO3. Examples of the material for the electron transport layer include $ZnO_2$ and $TiO_2$.

The upper electrode 253 is preferably a transparent electrode made of a conductive material that is transparent to light in a wavelength range of 400 to ($\lambda_{max}$ + 300) nm. The lower electrode 252 may be a transparent electrode in the same manner as the upper electrode 253, or may not be a transparent electrode. The expression "transparent to light of a certain wavelength" as used in the present specification means transmitting 70% or more of light of that wavelength. The light transmittance of the upper electrode 253 for light in a wavelength range of 400 to ($\lambda_{max}$ + 300) nm is preferably 90% or more and more preferably 95% or more.

Suitable examples of the material for the upper electrode 253 and the lower electrode 252 include a metal, an alloy, a metal oxide, a metal nitride, a metal boride, an organic conductive compound, and a mixture thereof. Specific examples thereof include a conductive metal oxide such as tin oxide, zinc oxide, indium oxide, indium zinc oxide (IZO), indium tin oxide (ITO), or indium tungsten oxide (IWO); a metal nitride such as titanium nitride; a metal such as gold, platinum, silver, chromium, nickel, or aluminum; a mixture or laminate of such a metal and a conductive metal oxide; an inorganic conductive material such as copper iodide or copper sulfide; an organic conductive material such as polyaniline, polythiophene, or polypyrrole; and a laminate thereof with ITO.

The method for forming the electrodes (upper electrode and lower electrode) can be appropriately selected depending on the material used. For example, in a case of indium tin oxide (ITO), the electrode can be formed using an electron beam method, a sputtering method, a resistance heating vapor deposition method, a chemical reaction method (such as a sol-gel method), a method of applying a dispersion of indium tin oxide, or the like.

Although not shown, the electrodes may be separated and the light receiving section of the photoelectric conversion element 201 may be divided into a plurality of light receiving sections.

The photoelectric conversion layer 251 includes quantum dots having a maximum absorption wavelength $\lambda_{max}$ in the infrared range having a wavelength of 800 nm or longer. The maximum absorption wavelength $\lambda_{max}$ of the quantum dot is preferably in a range of 800 to 4000 nm, more preferably in a range of 800 to 3000 nm, and still more preferably in a range of 800 to 2000 nm. Examples of the material for the quantum dot include the materials described hereinbefore.

Examples of the method for forming the photoelectric conversion layer 251 include a wet film forming method and a dry film forming method. Examples of the method for forming the photoelectric conversion layer 251 by the dry film forming method include a chemical vapor deposition method and a physical vapor deposition method. In a case where the photoelectric conversion layer 251 is formed by the wet film forming method, the photoelectric conversion layer 251 can be formed by applying a composition for a photoelectric conversion layer containing quantum dots and a solvent onto a support such as an electrode by a conventionally known coating method. Examples of the coating method include a drop casting method; a slit coating method; a spray coating method; a roll coating method; a spin coating method; a cast coating method; a slit and spin method; a pre-wetting method (for example, a method described in JP2009-145395A); various printing methods including a jet printing method such as an ink jet method (for example, an on-demand method, a piezoelectric method, or a thermal method) or a nozzle jet method, a flexographic printing method, a screen printing method, a gravure printing method, a reverse offset printing method, and a metal mask printing method; a transfer method using a mold or the like; and a nanoimprinting method.

In the optical sensor 1 shown in Fig. 1, an insulating layer 301 is provided on the photoelectric conversion element 201. The insulating layer 301 may be an inorganic film or an organic film. The inorganic film is preferable from the viewpoint of insulating properties and reduced film thickness. Examples of the insulating layer of the inorganic film include an oxide. Examples of the insulating layer of the organic film include a resin film.

The light transmittance indicated by the insulating layer 301 for light in a wavelength range of 400 to 4000 nm is preferably high, more preferably 70% or more, still more preferably 80% or more, even still more preferably 90% or more, and particularly preferably 95% or more.

In the optical sensor 1 shown in Fig. 1, an infrared transmitting filter 401 is provided on the insulating layer 301. The maximum value of the light transmittance indicated by the infrared transmitting filter 401 for light in the infrared

range having a wavelength of 800 nm or longer is preferably 60% or more, more preferably 80% or more, and still more preferably 90% or more. In addition, the infrared transmitting filter 401 preferably has high transmittance of light of a target wavelength to be received by the infrared light receiving section of the photoelectric conversion element 201, among the light in a wavelength range in the infrared range having a wavelength of 800 nm or longer; and more preferably has a light transmittance of 60% or more, still more preferably 70% or more, and particularly preferably 80% or more for light having the above-mentioned wavelength. For example, in a case where the infrared light receiving section of the photoelectric conversion element 201 receives light of any wavelength in a range of the maximum absorption wavelength $\lambda_{max}$ of the quantum dot contained in the photoelectric conversion layer 251 $\pm$ 50 nm, the maximum value of the light transmittance indicated by the infrared transmitting filter 401 for light in a range of the maximum absorption wavelength $\lambda_{max}$ of the quantum dot $\pm$ 50 nm is more preferably 60% or more, still more preferably 70% or more, and particularly preferably 80% or more.

In addition, the infrared transmitting filter 401 preferably has low transmittance for light in a wavelength range in the visible range, and more preferably has an average light transmittance of 10% or less, still more preferably 7.5% or less, and particularly preferably 5% or less for light in a wavelength range of 400 to 650 nm.

Examples of the infrared transmitting filter 401 include those made of a resin film containing a coloring material. Examples of the coloring material include chromatic coloring materials such as a red coloring material, a green coloring material, a blue coloring material, a yellow coloring material, a violet coloring material, and an orange coloring material. The coloring material contained in the infrared transmitting filter 401 preferably forms black by combination of two or more types of chromatic coloring materials. Examples of the combination of the chromatic coloring materials in a case of forming black by the combination of two or more types of chromatic coloring materials include the above-mentioned aspects (C1) to (C7).

The infrared transmitting filter 401 may further contain an infrared absorber. The wavelength of the transmitted light can be shifted to the longer wavelength side by including the infrared absorber in the infrared transmitting filter 401. Examples of the infrared absorber include the infrared absorbers described hereinbefore.

The infrared transmitting filter 401 can be formed by using a composition containing a coloring material and a resin. Examples of the composition used for forming the infrared transmitting filter 401 include the composition described in WO2016/190162A.

The infrared transmitting filter 401 preferably has a wavelength having a light transmittance of 50% in a range of the maximum absorption wavelength $\lambda_{max}$ of the quantum dot contained in the photoelectric conversion layer 251 - 200 nm or longer and the maximum absorption wavelength $\lambda_{max}$ of the quantum dot + 20 nm or shorter (preferably in a range of $\lambda_{max}$ - 175 to $\lambda_{max}$ + 20 nm, and more preferably in a range of $\lambda_{max}$ - 150 to $\lambda_{max}$ + 20 nm). In addition, the maximum value of the light transmittance indicated by the infrared transmitting filter 401 for light in a range of the maximum absorption wavelength $\lambda_{max}$of the quantum dot $\pm$ 50 nm is preferably 70% or more and more preferably 90% or more.

Although not shown, the infrared transmitting filter 401 may include a plurality of pixels having different wavelengths of transmitted light. In addition, a partition wall may be provided between the pixels. In a case where the infrared transmitting filter 401 includes a plurality of such pixels, it is preferable that, in the photoelectric conversion element 201, the electrodes are separated and the light receiving section is divided into a plurality of light receiving sections. In addition, in the photoelectric conversion layer 251 of the photoelectric conversion element 201, each of the regions (light receiving sections) that receive light transmitted through each pixel of the infrared transmitting filter 401 may be compartmented by a partition wall or a groove.

In the optical sensor 1 shown in Fig. 1, a bandpass filter 501 is provided on the infrared transmitting filter 401.

Although the bandpass filter 501 is provided at a distance above the infrared transmitting filter 401 in Fig. 1, the bandpass filter 501 may be provided on the surface of the infrared transmitting filter 401. In addition, an interlayer such as an adhesive layer or a planarizing layer may be provided between the infrared transmitting filter 401 and the bandpass filter 501.

Examples of the bandpass filter 501 include a dielectric multi-layer film. Examples of the dielectric multi-layer film include the dielectric multi-layer films described hereinbefore.

The bandpass filter 501 preferably has a transmission wavelength range in the infrared range having a wavelength of 800 nm or longer. In addition, it is preferable that the wavelength range of the transmission wavelength range of the bandpass filter 501 includes a target wavelength to be received by the infrared light receiving section. In addition, the maximum light transmittance in the transmission wavelength range is preferably 70% or more, more preferably 80% or more, and still more preferably 90% or more. In addition, the maximum light transmittance in the light-shielding wavelength range is preferably 20% or less, more preferably 15% or less, and still more preferably 10% or less. In addition, the average light transmittance in the transmission wavelength range is preferably 60% or more, more preferably 70% or more, and still more preferably 80% or more. In addition, in a case where the wavelength showing the maximum light transmittance is defined as a central wavelength $\lambda_{tl}$, the wavelength range of the transmission wavelength range is preferably the central wavelength $\lambda_{tl}$ $\pm$ 100 nm, more preferably the central wavelength $\lambda_{tl}$ $\pm$ 50 nm, and still more

preferably the central wavelength $\lambda_{tl} \pm 25$ nm.

The bandpass filter 501 may have only one transmission wavelength range (preferably, a transmission wavelength range having a maximum light transmittance of 90% or more), or may have a plurality of transmission wavelength ranges. In the optical sensor having the structure shown in Fig. 1, it is preferable that the bandpass filter 501 has only one transmission wavelength range.

In addition, the average light transmittance indicated by the bandpass filter 501 for light in a wavelength range of 400 to 650 nm is preferably low, more preferably 10% or less, still more preferably 5% or less, and particularly preferably 2% or less.

In the optical sensor 1 shown in Fig. 1, an infrared transmitting member 601 is configured of the infrared transmitting filter 401 and the bandpass filter 501. Therefore, the optical sensor 1 shown in Fig. 1 satisfies the spectral characteristics that the maximum value of the light transmittance for light in the infrared range having a wavelength of 800 nm or longer is 60% or more and the average light transmittance for light in a wavelength range of 400 to 650 nm is 10% or less, in combined total of values of the infrared transmitting filter 401 and the bandpass filter 501. The above-mentioned aspects can be mentioned as preferred aspects of the spectral characteristics of the infrared transmitting member 601.

In the optical sensor 1 shown in Fig. 1, the infrared transmitting member 601 is configured of the infrared transmitting filter 401 and the bandpass filter 501; but the bandpass filter 501 may be omitted in a case where the infrared transmitting filter 401 satisfies the spectral characteristics that the maximum value of the light transmittance for light in the infrared range having a wavelength of 800 nm or longer is 60% or more and the average light transmittance for light in a wavelength range of 400 to 650 nm is 10% or less. Similarly, the infrared transmitting filter 401 may be omitted in a case where the bandpass filter 501 satisfies the above-mentioned spectral characteristics.

In addition, although not shown in Fig. 1, the optical sensor 1 may further have a light emitting device. The light emitting device is preferably arranged such that light can be incident on the photoelectric conversion element 201. The type of the light emitting device is not particularly limited, and examples thereof include a light emitting diode and a laser. The light emitting device preferably has an emission maximum in a range of the maximum absorption wavelength $\lambda_{max}$ of the quantum dot $\pm$ 50 nm.

Specific aspects of the optical sensor 1 shown in Fig. 1 include the aspects shown in the following tables. The spectral characteristics of the infrared transmitting member 601 are the spectral characteristics in combined total of the spectral characteristics of the infrared transmitting filter 401 and the bandpass filter 501.

[Table 2]

| | Quantum dots | Infrared transmitting member 601 | Light source | | Applications |
|---|---|---|---|---|---|
| | Maximum absorption wav elength $\lambda_{max}$ (nm) | Spectral characteristics | Emission max imum (nm) | Half-width (nm) | |
| No1-1 | 850 | Average light transmittance of 10% or less for light in wavelength range of 400 to 650 nm.<br>Maximum value of light transmittance of 90% or more in wavelength range of 800 to 900 nm.<br>Light transmittance of 90% or more for light having wavelength of 850 nm.<br>Wavelength having light transmittance of 50% in wavelength range of 400 to 850 nm i s 800 nm.<br>Light transmittance of 15% or less for light having wavelength of 680 nm. | 850 | 50 | Automatic operation device, dist ance measurement device |

(continued)

| | Quantum dots | Infrared transmitting member 601 | Light source | | Applications |
|---|---|---|---|---|---|
| | Maximum absorption wav elength $\lambda_{max}$ (nm) | Spectral characteristics | Emission max imum (nm) | Half-width (nm) | |
| No1-2 | 905 | Average light transmittance of 10% or less for light in wavelength range of 400 to 650 nm. Maximum value of light transmittance of 90% or more in wavelength range of 880 to 925 nm. Light transmittance of 90% or more for light having wavelength of 905 nm. Wavelength having light transmittance of 50% in wavelength range of 400 to 905 nm i s 860 nm. Light transmittance of 18% or less for light having wavelength of 724 nm. | 905 | 50 | Automatic operation device, dist ance measurement device |
| No1-3 | 940 | Average light transmittance of 10% or less for light in wavelength range of 400 to 650 nm. Maximum value of light transmittance of 90% or more in wavelength range of 900 to 980 nm. Light transmittance of 90% or more for light having wavelength of 940 nm. Wavelength having light transmittance of 50% in wavelength range of 400 to 940 nm i s 850 nm. Light transmittance of 10% or less for light having wavelength of 752 nm. | 940 | 50 | Automatic operation device, dist ance measurement device |

[Table 3]

| | Quantum dots | Infrared transmitting member 601 | Light source | | Applications |
|---|---|---|---|---|---|
| | Maximum absorption wavelength $\lambda_{max}$ (nm) | Spectral characteristics | Emission maximum (nm) | Half-width (nm) | |
| No1-4 | 1120 | Average light transmittance of 10% or less for light in wavelength range of 400 to 650 nm.<br>Maximum value of light transmittance of 70% or more in wavelength range of 1070 to 1170 nm.<br>Light transmittance of 70% or more for light having wavelength of 1120 nm.<br>Wavelength having light transmittance of 50% in wavelength range of 400 to 1120 nm is 1020 nm.<br>Light transmittance of 14% or less for light having wavelength of 896 nm. | 1120 | 50 | Automatic operation device, distance measurement device |
| No1-5 | 1250 | Average light transmittance of 10% or less for light in wavelength range of 400 to 650 nm.<br>Maximum value of light transmittance of 80% or more in wavelength range of 1200 to 1300 nm.<br>Light transmittance of 90% or more for light having wavelength of 1250 nm.<br>Wavelength having light transmittance of 50% in wavelength range of 400 to 1250 nm is 1075 nm.<br>Light transmittance of 18% or less for light having wavelength of 1000 nm. | 1250 | 50 | Automatic operation device, distance measurement device |

[Table 4]

| | Quantum dots | Infrared transmitting member 601 | Light source | | Applications |
|---|---|---|---|---|---|
| | Maximum absorption wavelength $\lambda_{max}$ (nm) | Spectral characteristics | Emission maximum (nm) | Half-width (nm) | |
| No1-6 | 1380 | Average light transmittance of 10% or less for light in wavelength range of 400 to 650 nm.<br>Maximum value of light transmittance of 60% or more in wavelength range of 1330 to 1430 nm.<br>Light transmittance of 60% or more for light having wavelength of 1380 nm.<br>Wavelength having light transmittance of 50% in wavelength range of 400 to 1380 nm is 1200 nm.<br>Light transmittance of 10% or less for light having wavelength of 1104 nm. | 1380 | 50 | Automatic operation device, distance measurement device |
| No1-7 | 1550 | Average light transmittance of 10% or less for light in wavelength range of 400 to 650 nm.<br>Maximum value of light transmittance of 80% or more in wavelength range of 1500 to 1580 nm.<br>Light transmittance of 80% or more for light having wavelength of 1550 nm.<br>Wavelength having light transmittance of 50% in wavelength range of 400 to 1550 nm is 1350 nm.<br>Light transmittance of 10% or less for light having wavelength of 1240 nm. | 1550 | 50 | Automatic operation device, distance measurement device |

(Second embodiment)

The optical sensor of the second embodiment will be described with reference to Fig. 3. An optical sensor 2 shown in Fig. 3 is different from the optical sensor of the first embodiment in that a microlens 702 is provided between an infrared transmitting filter 402 and a bandpass filter 502.

In the optical sensor of this embodiment, an infrared transmitting member 602 is configured of the infrared transmitting filter 402, the bandpass filter 502, and the microlens 702. Therefore, the optical sensor 1 shown in Fig. 3 satisfies the spectral characteristics that the maximum value of the light transmittance for light in the infrared range having a wavelength of 800 nm or longer is 60% or more and the average light transmittance for light in a wavelength range of 400 to 650 nm is 10% or less, in combined total of values of the infrared transmitting filter 402, the bandpass filter 502, and the microlens 702. The above-mentioned aspects can be mentioned as preferred aspects of the spectral

characteristics of the infrared transmitting filter 402, the bandpass filter 502, and the infrared transmitting member 602.

The light transmittance indicated by the microlens 702 for light in the infrared range having a wavelength of 800 nm or longer is preferably high, and the maximum value of the above-mentioned light transmittance is more preferably 60% or more, still more preferably 80% or more, and particularly preferably 90% or more. In addition, the microlens 702 preferably has high transmittance of light of a target wavelength to be received by the infrared light receiving section of the photoelectric conversion element 201, among the light in a wavelength range in the infrared range having a wavelength of 800 nm or longer; and more preferably has a light transmittance of 60% or more, still more preferably 70% or more, and particularly preferably 80% or more for light having the above-mentioned wavelength.

The microlens 702 preferably has a high refractive index for light having the maximum absorption wavelength $\lambda_{max}$ of the quantum dot contained in the photoelectric conversion layer, more preferably a refractive index of 1.8 or more, and still more preferably a refractive index of 1.9 or more, from the viewpoint that it is easy to improve the light focusing properties and suppress light leakage or the like.

In the optical sensor shown in Fig. 3, the microlens 702 is provided between the infrared transmitting filter 402 and the bandpass filter 502; but the microlens 702 may be provided on the light incident side of the bandpass filter 502.

In addition, although not shown in Fig. 3, the optical sensor 2 may further have a light emitting device as in the optical sensor 1 of the first embodiment.

In addition, in the optical sensor 1 shown in Fig. 3, the infrared transmitting member 602 is configured of the infrared transmitting filter 402, the bandpass filter 502, and the microlens 702; but the bandpass filter 502 may be omitted in a case where the above-mentioned spectral characteristics are satisfied by the infrared transmitting filter 402 and the microlens 702. Similarly, the infrared transmitting filter 402 may be omitted in a case where the above-mentioned spectral characteristics are satisfied by the bandpass filter 502 and the microlens 702.

Specific aspects of the optical sensor 2 shown in Fig. 3 include the aspects shown in the following tables. The spectral characteristics of the infrared transmitting member 602 are the spectral characteristics in combined total of the spectral characteristics of the infrared transmitting filter 402, the bandpass filter 502, and the microlens 702.

[Table 5]

| | Quantum dots | Infrared transmitting member 602 | | Light source | | Applications |
|---|---|---|---|---|---|---|
| | Maximum absorption wavelength $\lambda_{max}$ (nm) | Spectral characteristics | Refractive index of microlens 702 | Emission maximum (nm) | Half-width (nm) | |
| No2-1 | 850 | Average light transmittance of 10% or less for light in wavel ength range of 400 to 650 nm. Maximum value of light transmittance of 90% or more in wa velength range of 800 to 900 nm. Light transmittance of 90% or more for light having wavelen gth of 850 nm. Wavelength having light transmittance of 50% in wavelength range of 400 to 850 nm is 800 nm. Light transmittance of 15% or less for light having wavelengt h of 680 nm. | Refractive index of 1.8 to 2.2 for light having wavelength of 850 nm | 850 | 50 | Authentication sensor, motion sensor |

(continued)

| | Quantum dots | Infrared transmitting member 602 | | Light source | | Applications |
|---|---|---|---|---|---|---|
| | Maximum absorption wavelength $\lambda_{max}$ (nm) | Spectral characteristics | Refractive index of microlens 702 | Emission maximum (nm) | Half-width (nm) | |
| No2-2 | 905 | Average light transmittance of 10% or less for light in wavel ength range of 400 to 650 nm. Maximum value of light transmittance of 90% or more in wa velength range of 880 to 925 nm. Light transmittance of 90% or more for light having wavelen gth of 905 nm. Wavelength having light transmittance of 50% in wavelength range of 400 to 905 nm is 860 nm. Light transmittance of 18% or less for light having wavelengt h of 724 nm. | Refractive index of 1.8 to 2.2 for light having wavelength of 905 nm | 905 | 50 | Authentication sensor, motion sensor |
| No2-3 | 940 | Average light transmittance of 10% or less for light in wavelength range of 400 to 650 nm. Maximum value of light transmittance of 90% or more in wavelength range of 900 to 980 nm. Light transmittance of 90% or more for light having wa velength of 940 nm. Wavelength having light transmittance of 50% in wavele ngth range of 400 to 940 nm is 850 nm. Light transmittance of 10% or less for light having wav elength of 752 nm. | Refractive index of 1.8 to 2.2 for light having wavelength of 940 nm | 940 | 50 | Authentication sensor, motion sensor |

(continued)

| | Quantum dots | Infrared transmitting member 602 | | Light source | | Applications |
|---|---|---|---|---|---|---|
| | Maximum absorption wavelength $\lambda_{max}$ (nm) | Spectral characteristics | Refractive index of microlens 702 | Emission maximum (nm) | Half-width (nm) | |
| No2-4 | 1120 | Average light transmittance of 10% or less for light in wavelength range of 400 to 650 nm. Maximum value of light transmittance of 70% or more in wavelength range of 1070 to 1170 nm. Light transmittance of 70% or more for light having wa velength of 1120 nm. Wavelength having light transmittance of 50% in wavele ngth range of 400 to 1120 nm is 1020 nm. Light transmittance of 14% or less for light having wav elength of 896 nm. | Refractive index of 1.8 to 2.2 for light having wavelength of 1120 nm | 1120 | 50 | Authentication sensor, mo tion sensor |

[Table 6]

| | Quantum dots | Infrared transmitting member 602 | | Light source | | Applications |
|---|---|---|---|---|---|---|
| | Maximum absorption w avelength $\lambda_{max}$ (nm) | Spectral characteristics | Refractive index of microlens 702 | Emission m aximum (nm) | Half-width (nm) | |
| No2-5 | 1250 | Average light transmittance of 10% or less for light in wavelength range of 400 to 650 nm.<br>Maximum value of light transmittance of 80% or more in wavelength range of 1200 to 1300 nm.<br>Light transmittance of 90% or more for light having wavelength of 1250 n m.<br>Wavelength having light transmittance of 50% in wavelength range of 400 t o 1250 nm is 1075 nm.<br>Light transmittance of 18% or less for light having wavelength of 1000 nm. | Refractive index of 1.8 to 2. 2 for light having wavelengt h of 1250 nm | 1250 | 50 | Authentication sensor, motion sensor |
| No2-6 | 1380 | Average light transmittance of 10% or less for light in wavelength range of 400 to 650 nm.<br>Maximum value of light transmittance of 60% or more in wavelength range of 1330 to 1430 nm.<br>Light transmittance of 60% or more for light having wavelength of 1380 n m.<br>Wavelength having light transmittance of 50% in wavelength range of 400 t o 1380 nm is 1200 nm.<br>Light transmittance of 10% or less for light having wavelength of 1104 nm. | Refractive index of 1.8 to 2. 2 for light having wavelengt h of 1380 nm | 1380 | 50 | Authentication sensor, motion sensor |

(continued)

| | Quantum dots | Infrared transmitting member 602 | | Light source | | Applications |
|---|---|---|---|---|---|---|
| | Maximum absorption w avelength $\lambda_{max}$ (nm) | Spectral characteristics | Refractive index of microlens 702 | Emission m aximum (nm) | Half-width (nm) | |
| No2-7 | 1550 | Average light transmittance of 10% or less for light in wavelength range of 400 to 650 nm. Maximum value of light transmittance of 80% or more in wavelength range of 1500 to 1580 nm. Light transmittance of 80% or more for light having wavelength of 1550 n m. Wavelength having light transmittance of 50% in wavelength range of 400 t o 1550 nm is 1350 nm. Light transmittance of 10% or less for light having wavelength of 1240 nm. | Refractive index of 1.8 to 2. 2 for light having wavelengt h of 1550 nm | 1550 | 50 | Authentication sensor, motion sensor |

(Third embodiment)

The optical sensor of the third embodiment will be described with reference to Fig. 4. A photoelectric conversion element 203 of an optical sensor 3 shown in Fig. 4 has a plurality of light receiving sections 203a to 203d. Each light receiving section receives light having a different wavelength. In the optical sensor 3 shown in Fig. 4, the light receiving section 203a is an infrared light receiving section. The light receiving sections 203b to 203d are preferably light receiving sections that receive light on a shorter wavelength side than the wavelength of light received by the light receiving section 203a (infrared light receiving section). Examples of such a light receiving section include a light receiving section that receives visible light such as red light, blue light, green light, yellow light, magenta light, and cyan light (visible light receiving section). In addition, the light receiving sections 203b to 203d may be light receiving sections that receive infrared light on a shorter wavelength side than the wavelength of infrared light received by the light receiving section 203a.

In the optical sensor 3 shown in Fig. 4, an optical filter 803 is provided on the insulating layer 301. The optical filter 803 includes pixels 811 to 814 having different wavelengths of transmitted light. It is preferable that each of the pixels 811 to 814 of the optical filter 803 is a resin film containing a coloring material. The pixel 811 is a part of the members constituting the infrared transmitting member in the present invention.

Of the plurality of pixels included in the optical filter 803, the pixel 811 located on the optical path on the light incident side with respect to the light receiving section 203a (infrared light receiving section) of the photoelectric conversion element 203 is a pixel of the infrared transmitting filter. The maximum value of the light transmittance indicated by the pixel 811 for light in the infrared range having a wavelength of 800 nm or longer is preferably 60% or more, more preferably 80% or more, and still more preferably 90% or more. In addition, the pixel 811 preferably has high transmittance of light having a wavelength to be received by the light receiving section 203a (infrared light receiving section) of the photoelectric conversion element 203, among the light in a wavelength range in the infrared range having a wavelength of 800 nm or longer; and more preferably has a light transmittance of 60% or more, still more preferably 70% or more, and particularly preferably 80% or more for light having the above-mentioned wavelength. In addition, in a case where the light receiving section 203a (infrared light receiving section) of the photoelectric conversion element 203 receives

light of any wavelength in a range of the maximum absorption wavelength $\lambda_{max}$ of the quantum dot contained in the photoelectric conversion element 203 $\pm$ 50 nm, the maximum value of the light transmittance indicated by the pixel 811 for light in a range of the maximum absorption wavelength $\lambda_{max}$ of the quantum dot $\pm$ 50 nm is more preferably 60% or more, still more preferably 70% or more, and particularly preferably 80% or more.

Of the plurality of pixels included in the optical filter 803, the pixels 812 to 814 located on the optical paths on the light incident side with respect to the light receiving sections 203b to 203d of the photoelectric conversion element 203 may be any pixels that transmit light having a wavelength different from the wavelength of light transmitted through the pixel 811. The pixels 812 to 814 are not particularly limited and are preferably pixels that transmit light having a wavelength on a shorter wavelength side than the wavelength of light transmitted through the pixel 811. For example, the pixels 812 to 814 are preferably pixels having a wavelength having a light transmittance of 60% or more in a range of 400 nm or longer and the maximum absorption wavelength $\lambda_{max}$ of the quantum dot $\times$ 0.8 nm or shorter. Examples of such a pixel include colored pixels such as a red pixel, a blue pixel, a green pixel, a yellow pixel, a cyan pixel, and a magenta pixel. Specific examples of the combination of pixels 812 to 814 include a combination in which the pixel 812 is a red pixel, the pixel 813 is a blue pixel, and the pixel 814 is a green pixel, and a combination in which the pixel 812 is a yellow pixel, the pixel 813 is a cyan pixel, and the pixel 814 is a magenta pixel.

In a case where the pixels 812 to 814 are colored pixels, it is preferable that an infrared cut filter is provided on the surface of the pixels 812 to 814 on the light incident side or the surface of the pixels 812 to 814 on the light emitting side. According to this aspect, it is possible to increase the sensitivity of visible light in the light receiving sections 203b to 203d and reduce noise derived from infrared rays. Such an optical filter may be, for example, an optical filter shown in Fig. 5. In Fig. 5, reference numeral 811a is a pixel of an infrared transmitting filter, reference numeral 812a to 814a are colored pixels, and reference numeral 820 is an infrared cut filter.

The optical filter 803 of the optical sensor 3 shown in Fig. 4 has four types of pixels (pixels 811 to 814), but the type of pixel may be two types, three types, or five or more types. The type of pixel can be appropriately adjusted according to the application and purpose. In addition, although not shown, each pixel of the optical filter 803 may be compartmented by a partition wall. Examples of the partition wall include the partition walls described hereinbefore.

In the optical sensor 3 shown in Fig. 4, microlenses 703a to 703d are provided on the optical filter 803. The microlens 703a located on the optical path of the light receiving section 203a (infrared light receiving section) of the photoelectric conversion element 203 is a part of the members constituting the infrared transmitting member in the present invention.

The microlens 703a and the microlenses 703b to 703d may have the same spectral characteristics or may have different spectral characteristics. In a case where the microlens 703a and the microlenses 703b to 703d have the same spectral characteristics, these microlenses can be produced in the same step and therefore the number of microlens production steps can be reduced, resulting in excellent productivity. In addition, in a case where the microlens 703a and the microlenses 703b to 703d have different spectral characteristics, the sensitivity of light received by each light receiving section can be increased or the noise can be further reduced.

The light transmittance indicated by the microlens 703a located on the optical path of the light receiving section 203a (infrared light receiving section) of the photoelectric conversion element 203 for light in the infrared range having a wavelength of 800 nm or longer is preferably high, and the maximum value of the above-mentioned light transmittance is more preferably 60% or more, still more preferably 80% or more, and particularly preferably 90% or more. In addition, the microlens 703a preferably has high transmittance of light of a target wavelength to be received by the light receiving section 203a (infrared light receiving section) of the photoelectric conversion element 203, among the light in a wavelength range in the infrared range having a wavelength of 800 nm or longer; and more preferably has a light transmittance of 60% or more, still more preferably 70% or more, and particularly preferably 80% or more for light having the above-mentioned wavelength. In addition, the microlens 703a preferably has a high refractive index for light having the maximum absorption wavelength $\lambda_{max}$ of the quantum dot contained in the photoelectric conversion layer, more preferably a refractive index of 1.8 or more, and still more preferably a refractive index of 1.9 or more, from the viewpoint that it is easy to improve the light focusing properties and suppress light leakage or the like.

The microlenses 703b to 703d located on the optical paths of the light receiving sections 203b to 203d of the photoelectric conversion element 203 preferably has high transmittance of light of a target wavelength to be received by the light receiving sections 203b to 203d; and more preferably has a light transmittance of 60% or more, still more preferably 80% or more, and particularly preferably 90% or more for light having the above-mentioned wavelength. In addition, the microlenses 703b to 703d preferably have a refractive index of 1.8 or more and more preferably 1.9 or more for light having a wavelength of 589.3 nm.

In addition, it is also preferable that all of the microlenses 703a to 703d have a minimum value of light transmittance of 60% or more (preferably 80% or more, and more preferably 90% or more) for light in a wavelength range of 400 to $\lambda_{max} \times$ 1.2 nm. In addition, it is also preferable that all of the microlenses 703a to 703d have a refractive index of 1.8 or more (preferably 1.9 or more) for light having a wavelength of 589.3 nm.

In the optical sensor 3 shown in Fig. 4, a bandpass filter 503 is provided on the microlenses 703a to 703d. The

bandpass filter 503 is a part of the members constituting the infrared transmitting member in the present invention.

Although the bandpass filter 503 is provided at a distance above the microlenses 703a to 703d in Fig. 4, the bandpass filter 503 may be provided on the surface of the microlenses 703a to 703d. In addition, an interlayer such as an adhesive layer or a planarizing layer may be provided between the microlenses 703a to 703d and the bandpass filter 503.

Examples of the bandpass filter 503 include a dielectric multi-layer film. Examples of the dielectric multi-layer film include the dielectric multi-layer films described hereinbefore.

The bandpass filter 503 preferably has a transmission wavelength range in the infrared range having a wavelength of 800 nm or longer. In addition, it is preferable that the wavelength range of the transmission wavelength range of the bandpass filter 503 includes a target wavelength to be received by the light receiving sections 203a to 203d. The transmission wavelength range of the bandpass filter 503 may be only one or may be two or more. In a case where there are two or more transmission wavelength ranges, the wavelength range of any of the transmission wavelength ranges may include a target wavelength to be received by the light receiving sections 203a to 203d.

The maximum light transmittance in the transmission wavelength range is preferably 60% or more, more preferably 80% or more, and still more preferably 90% or more. In addition, the maximum light transmittance in the light-shielding wavelength range is preferably 20% or less, more preferably 15% or less, and still more preferably 10% or less. In addition, the average light transmittance in the transmission wavelength range is preferably 60% or more, more preferably 70% or more, and still more preferably 80% or more. In addition, in a case where the wavelength showing the maximum light transmittance is defined as a central wavelength $\lambda_{tl}$, the wavelength range of the transmission wavelength range is preferably the central wavelength $\lambda_{tl} \pm 100$ nm, more preferably the central wavelength $\lambda_{tl} \pm 50$ nm, and still more preferably the central wavelength $\lambda_{tl} \pm 25$ nm.

In the optical sensor 3 shown in Fig. 4, an infrared transmitting member 603 is configured of the pixel 811 of the optical filter 803, the microlens 703a, and the bandpass filter 503. Therefore, the optical sensor 3 shown in Fig. 4 satisfies the spectral characteristics that the maximum value of the light transmittance for light in the infrared range having a wavelength of 800 nm or longer is 60% or more and the average light transmittance for light in a wavelength range of 400 to 650 nm is 10% or less, in combined total of values of the pixel 811 of the optical filter 803, the microlens 703a, and the bandpass filter 503. The above-mentioned aspects can be mentioned as preferred aspects of the spectral characteristics of the infrared transmitting member 603.

Although not shown in Fig. 4, the optical sensor 3 may further have a light emitting device as in the optical sensor 1 of the first embodiment.

In addition, in the optical sensor 1 shown in Fig. 4, the infrared transmitting member 603 is configured of the pixel 811 of the optical filter 803, the microlens 703a, and the bandpass filter 503; but the bandpass filter 503 may be omitted in a case where the above-mentioned spectral characteristics are satisfied by the pixel 811 of the optical filter 803 and the microlens 703a.

Specific aspects of the optical sensor 3 shown in Fig. 4 include the aspects shown in the following tables. The spectral characteristics of the infrared transmitting member 603 are the spectral characteristics in combined total of the spectral characteristics of the pixel 811, the microlens 703a, and the bandpass filter 503.

[Table 7]

| | Quantum dots | Infrared transmitting member 603 | | Pixel 812 | Pixel 813 | Pixel 814 | Light source | | Applications |
|---|---|---|---|---|---|---|---|---|---|
| | Maximum absorption wavelength $\lambda_{max}$ (nm) | Spectral characteristics | Refractive index of microlens | | | | Emission maximum (nm) | Half-width (nm) | |
| No3-1 | 850 | Average light transmittance of 10% or less for lig ht in wavelength range of 400 to 650 nm.<br>Maximum value of light transmittance of 90% or more in wavelength range of 800 to 900 nm.<br>Light transmittance of 90% or more for light havi ng wavelength of 850 nm.<br>Wavelength having light transmittance of 50% in wavelength range of 400 to 850 nm is 800 nm.<br>Light transmittance of 15% or less for light havin g wavelength of 680 nm. | (Microlens 703a) Refractive index of 1.8 to 2.2 for lig ht having wavelen gth of 850 nm (Microlenses 703b to 703d) Refractive index of 1.8 to 2.2 for lig ht having wavelen gth of 589.3 nm | Red pixel | Blue pixel | Green pixel | 850 | 50 | Authentication sensor, motion sensor |

(continued)

| | Quantum dots | Infrared transmitting member 603 | | Pixel 812 | Pixel 813 | Pixel 814 | Light source | | Applications |
|---|---|---|---|---|---|---|---|---|---|
| | Maximum absorption wavelength $\lambda_{max}$ (nm) | Spectral characteristics | Refractive index of microlens | | | | Emission maximum (nm) | Half-width (nm) | |
| No3-2 | 905 | Average light transmittance of 10% or less for lig ht in wavelength range of 400 to 650 nm.<br>Maximum value of light transmittance of 90% or more in wavelength range of 880 to 925 nm.<br>Light transmittance of 90% or more for light havi ng wavelength of 905 nm.<br>Wavelength having light transmittance of 50% in wavelength range of 400 to 905 nm is 860 nm.<br>Light transmittance of 18% or less for light havin g wavelength of 724 nm. | (Microlens 703a) Refractive index of 1.8 to 2.2 for lig ht having wavelen gth of 905 nm (Microlenses 703b to 703d) Refractive index of 1.8 to 2.2 for lig ht having wavelen gth of 589.3 nm | Red pixel | Blue pixel | Green pixel | 905 | 50 | Authentication sensor, motion sensor |

(continued)

| | Quantum dots | Infrared transmitting member 603 | | Pixel 812 | Pixel 813 | Pixel 814 | Light source | | Applications |
|---|---|---|---|---|---|---|---|---|---|
| | Maximum absorption wavelength $\lambda_{max}$ (nm) | Spectral characteristics | Refractive index of microlens | | | | Emission maximum (nm) | Half-width (nm) | |
| No3-3 | 940 | Average light transmittance of 10% or less for light in wavelength range of 400 to 650 nm.<br>Maximum value of light transmittance of 90% or m ore in wavelength range of 900 to 980 nm.<br>Light transmittance of 90% or more for light havin g wavelength of 940 nm.<br>Wavelength having light transmittance of 50% in w avelength range of 400 to 940 nm is 850 nm.<br>Light transmittance of 10% or less for light having wavelength of 752 nm. | (Microlens 703a) Refractive index of 1.8 to 2.2 f or light having wavelength of 9 40 nm (Microlenses 703 b to 703d) Refractive index of 1.8 to 2.2 f or light having wavelength of 5 89.3 nm | Red pixel | Blue pixel | Green pixel | 940 | 50 | Authentication sensor, motion sensor |

(continued)

| | Quantum dots | Infrared transmitting member 603 | | Pixel 812 | Pixel 813 | Pixel 814 | Light source | | Applications |
|---|---|---|---|---|---|---|---|---|---|
| | Maximum absorption wavelength $\lambda_{max}$ (nm) | Spectral characteristics | Refractive index of microlens | | | | Emission maximum (nm) | Half-width (nm) | |
| No3-4 | 1120 | Average light transmittance of 10% or less for light in wavelength range of 400 to 650 nm.<br>Maximum value of light transmittance of 70% or m ore in wavelength range of 1070 to 1170 nm.<br>Light transmittance of 70% or more for light havin g wavelength of 1120 nm.<br>Wavelength having light transmittance of 50% in w avelength range of 400 to 1120 nm is 1020 nm.<br>Light transmittance of 14% or less for light having wavelength of 896 nm. | (Microlens 703a) Refractive index of 1.8 to 2.2 f or light having wavelength of 1 120 nm (Microlenses 703 b to 703d) Refractive index of 1.8 to 2.2 f or light having wavelength of 5 89.3 nm | Red pixel | Blue pixel | Green pixel | 1120 | 50 | Authentication sensor, motion sensor |

[Table 8]

| | Quantum dots | Infrared transmitting member 603 | | Pixel 812 | Pixel 813 | Pixel 814 | Light source | | Applications |
|---|---|---|---|---|---|---|---|---|---|
| | Maximum absorption wavelength $\lambda_{max}$ (nm) | Spectral characteristics | Refractive index of microlens | | | | Emission maximum (nm) | Half-width (nm) | |
| No3-5 | 1250 | Average light transmittance of 10% or less for light in wavelength range of 400 to 650 nm.<br>Maximum value of light transmittance of 80% or m ore in wavelength range of 1200 to 1300 nm.<br>Light transmittance of 90% or more for light havin g wavelength of 1250 nm.<br>Wavelength having light transmittance of 50% in w avelength range of 400 to 1250 nm is 1075 nm.<br>Light transmittance of 18% or less for light having wavelength of 1000 nm. | (Microlens 703a) Refractive index of 1.8 to 2.2 f or light having wavelength of 1 250 nm (Microlenses 703 b to 703d) Refractive index of 1.8 to 2.2 f or light having wavelength of 5 89.3 nm | Red pixel | Blue pixel | Green pixel | 1250 | 50 | Authentication sensor, motion sensor |

(continued)

| | Quantum dots | Infrared transmitting member 603 | | Pixel 812 | Pixel 813 | Pixel 814 | Light source | | Applications |
|---|---|---|---|---|---|---|---|---|---|
| | Maximum absorption wavelength $\lambda_{max}$ (nm) | Spectral characteristics | Refractive index of microlens | | | | Emission maximum (nm) | Half-width (nm) | |
| No3-6 | 1380 | Average light transmittance of 10% or less for light in wavelength range of 400 to 650 nm.<br>Maximum value of light transmittance of 60% or m ore in wavelength range of 1330 to 1430 nm.<br>Light transmittance of 60% or more for light havin g wavelength of 1380 nm.<br>Wavelength having light transmittance of 50% in w avelength range of 400 to 1380 nm is 1200 nm.<br>Light transmittance of 10% or less for light having wavelength of 1104 nm. | (Microlcns 703a) Refractive index of 1.8 to 2.2 f or light having wavelength of 1 380 nm (Microlenses 703 b to 703d) Refractive index of 1.8 to 2.2 f or light having wavelength of 5 89.3 nm | Red pixel | Blue pixel | Green pixel | 1380 | 50 | Authentication sensor, motion sensor |

(continued)

| | Quantum dots | Infrared transmitting member 603 | | | | | Light source | | |
|---|---|---|---|---|---|---|---|---|---|
| | Maximum absorption wavelength $\lambda_{max}$ (nm) | Spectral characteristics | Refractive index of microlens | Pixel 812 | Pixel 813 | Pixel 814 | Emission maximum (nm) | Half-width (nm) | Applications |
| No3-7 | 1550 | Average light transmittance of 10% or less for lig ht in wavelength range of 400 to 650 nm. Maximum value of light transmittance of 80% or more in wavelength range of 1500 to 1580 nm. Light transmittance of 80% or more for light havi ng wavelength of 1550 nm. Wavelength having light transmittance of 50% in wavelength range of 400 to 1550 nm is 1350 n m. Light transmittance of 10% or less for light havin g wavelength of 1240 nm. | (Microlens 703a) Refractive index of 1.8 to 2.2 for lig ht having wavelen gth of 1550 nm (Microlenses 703b to 703d) Refractive index of 1.8 to 2.2 for lig ht having wavelen gth of 589.3 nm | Red pixel | Blue pixel | Green pixel | 1550 | 50 | Authentication sensor, motion sensor |

(continued)

| | Quantum dots | Infrared transmitting member 603 | | | | | Light source | | |
|---|---|---|---|---|---|---|---|---|---|
| | Maximum absorption wavelength $\lambda_{max}$ (nm) | Spectral characteristics | Refractive index of microlens | Pixel 812 | Pixel 813 | Pixel 814 | Emission maximum (nm) | Half-width (nm) | Applications |
| No3-8 | 850 | Average light transmittance of 10% or less for lig ht in wavelength range of 400 to 650 nm.<br>Maximum value of light transmittance of 90% or more in wavelength range of 800 to 900 nm.<br>Light transmittance of 90% or more for light havi ng wavelength of 850 nm.<br>Wavelength having light transmittance of 50% in wavelength range of 400 to 850 nm is 800 nm.<br>Light transmittance of 15% or less for light havin g wavelength of 680 nm. | (Microlenses 703a to 703d) Refractive index of 1.8 to 2.2 for lig ht having wavelen gth of 589.3 nm | Red pixel | Blue pixel | Green pixel | 850 | 50 | Authentication sensor, motion sensor |

[Table 9]

| | Quantum dots | Infrared transmitting member 603 | | Pixel 812 | Pixel 813 | Pixel 814 | Light source | | Applications |
|---|---|---|---|---|---|---|---|---|---|
| | Maximum absorption wavelength $\lambda_{max}$ (nm) | Spectral characteristics | Refractive index of microlens | | | | Emission maximum (nm) | Half-width (nm) | |
| No3-9 | 905 | Average light transmittance of 10% or less for light in wavelength range of 400 to 6 50 nm.<br>Maximum value of light transmittance of 9 0% or more in wavelength range of 880 to 925 nm.<br>Light transmittance of 90% or more for lig ht having wavelength of 905 nm.<br>Wavelength having light transmittance of 5 0% in wavelength range of 400 to 905 nm is 860 nm.<br>Light transmittance of 18% or less for ligh t having wavelength of 724 nm. | (Microlenses 703a to 7 03d)<br>Refractive index of 1.8 to 2.2 for light h aving wavelength of 589.3 nm | Red pixel | Blue pixel | Green pixel | 905 | 50 | Authentication sensor, motion sensor |

(continued)

| | Quantum dots | Infrared transmitting member 603 | | Pixel 812 | Pixel 813 | Pixel 814 | Light source | | Applications |
|---|---|---|---|---|---|---|---|---|---|
| | Maximum absorption wavelength $\lambda_{max}$ (nm) | Spectral characteristics | Refractive index of microlens | | | | Emission maximum (nm) | Half-width (nm) | |
| No3-10 | 940 | Average light transmittance of 10% or less for light in wavelength range of 400 to 6 50 nm.<br>Maximum value of light transmittance of 9 0% or more in wavelength range of 900 to 980 nm.<br>Light transmittance of 90% or more for lig ht having wavelength of 940 nm.<br>Wavelength having light transmittance of 5 0% in wavelength range of 400 to 940 nm is 850 nm.<br>Light transmittance of 10% or less for ligh t having wavelength of 752 nm. | (Microlenses 703a to 7 03d) Refractive index of 1.8 to 2.2 for light h aving wavelength of 589.3 nm | Red pixel | Blue pixel | Green pixel | 940 | 50 | Authentication sensor, motion sensor |

(continued)

| | Quantum dots | Infrared transmitting member 603 | | | | | Light source | | |
|---|---|---|---|---|---|---|---|---|---|
| | Maximum absorption wavelength $\lambda_{max}$ (nm) | Spectral characteristics | Refractive index of microlens | Pixel 812 | Pixel 813 | Pixel 814 | Emission maximum (nm) | Half-width (nm) | Applications |
| No3-11 | 1120 | Average light transmittance of 10% or less for light in wavelength range of 400 to 6 50 nm.<br>Maximum value of light transmittance of 7 0% or more in wavelength range of 1070 t o 1170 nm.<br>Light transmittance of 70% or more for lig ht having wavelength of 1120 nm.<br>Wavelength having light transmittance of 5 0% in wavelength range of 400 to 1120 n m is 1020 nm.<br>Light transmittance of 14% or less for ligh t having wavelength of 896 nm. | (Microlenses 703a to 7 03d)<br>Refractive index of 1.8 to 2.2 for light h aving wavelength of 589.3 nm | Red pixel | Blue pixel | Green pixel | 1120 | 50 | Authentication sensor, motion sensor |

(continued)

| | Quantum dots | Infrared transmitting member 603 | | Pixel 812 | Pixel 813 | Pixel 814 | Light source | | Applications |
|---|---|---|---|---|---|---|---|---|---|
| | Maximum absorption wavelength $\lambda_{max}$ (nm) | Spectral characteristics | Refractive index of microlens | | | | Emission maximum (nm) | Half-width (nm) | |
| No3-12 | 1250 | Average light transmittance of 10% or less for light in wavelength range of 400 to 6 50 nm.<br>Maximum value of light transmittance of 8 0% or more in wavelength range of 1200 t o 1300 nm.<br>Light transmittance of 90% or more for lig ht having wavelength of 1250 nm.<br>Wavelength having light transmittance of 5 0% in wavelength range of 400 to 1250 n m is 1075 nm.<br>Light transmittance of 18% or less for ligh t having wavelength of 1000 nm. | (Microlenses 703a to 7 03d)<br>Refractive index of 1.8 to 2.2 for light h aving wavelength of 589.3 nm | Red pixel | Blue pixel | Green pixel | 1250 | 50 | Authentication sensor, motion sensor |

[Table 10]

| | Quantum dots | Infrared transmitting member 603 | | Pixel 812 | Pixel 813 | Pixel 814 | Light source | | Applications |
|---|---|---|---|---|---|---|---|---|---|
| | Maximum absorption wavelength $\lambda_{max}$ (nm) | Spectral characteristics | Refractive index of microlens | | | | Emission maximum (nm) | Half-width (nm) | |
| No3-13 | 1380 | Average light transmittance of 10% or less for light in wavelength range of 400 to 650 nm.<br>Maximum value of light transmittance of 60% or more in wavelength range of 1330 to 143 0 nm.<br>Light transmittance of 60% or more for light having wavelength of 1380 nm.<br>Wavelength having light transmittance of 50% in wavelength range of 400 to 1380 nm is 12 00 nm.<br>Light transmittance of 10% or less for light ha ving wavelength of 1104 nm. | (Microlenses 703a to 703d)<br>Refractive index of 1.8 to 2.2 for ligh t having wavelength of 589.3 nm | Red pixel | Blue pixel | Green pixel | 1380 | 50 | Authentication sensor, motion sensor |
| No3-14 | 1550 | Average light transmittance of 10% or less for light in wavelength range of 400 to 650 nm.<br>Maximum value of light transmittance of 80% or more in wavelength range of 1500 to 158 0 nm.<br>Light transmittance of 80% or more for light having wavelength of 1550 nm.<br>Wavelength having light transmittance of 50% in wavelength range of 400 to 1550 nm is 13 50 nm.<br>Light transmittance of 10% or less for light ha ving wavelength of 1240 nm. | (Microlenses 703a to 703d)<br>Refractive index of 1.8 to 2.2 for ligh t having wavelength of 589.3 nm | Red pixel | Blue pixel | Green pixel | 1550 | 50 | Authentication sensor, motion sensor |

<Sensing device>

The sensing device according to the embodiment of the present invention includes the above-mentioned optical sensor according to the embodiment of the present invention. Examples of the type of sensing device include a distance measurement device such as Time-of-Flight (TOF) camera, an infrared imaging apparatus, a visible-infrared imaging apparatus, a motion sensor, an authentication sensor, a proximity sensor, a gesture sensor, a surveillance camera, a moisture sensor, an automatic operation device, and an abnormality inspection device.

Explanation of References

| | |
|---|---|
| 1, 2, 3: | optical sensor |
| 101: | support |
| 201, 203: | photoelectric conversion element |
| 251: | photoelectric conversion layer |
| 252: | lower electrode |
| 253: | upper electrode |
| 301: | insulating layer |
| 401, 402: | infrared transmitting filter |
| 501, 502, 503: | bandpass filter |
| 601, 602, 603: | infrared transmitting member |
| 702, 703a, 703b, 703c, 703d: | microlens |
| 803: | optical filter |
| 811, 812, 813, 814: | pixel |
| 811a: | pixel of infrared transmitting filter |
| 812a, 813a, 814a: | colored pixel |
| 820: | infrared cut filter |

## Claims

**1.** An optical sensor comprising:

a photoelectric conversion element capable of acquiring light in a wavelength range including an infrared range, as an electric signal; and
an optical member provided on a light incident side with respect to the photoelectric conversion element,
wherein the photoelectric conversion element includes a quantum dot having a maximum absorption wavelength $\lambda_{max}$ in an infrared range having a wavelength of 800 nm or longer, and has an infrared light receiving section that receives light in a wavelength range in the infrared range, and
the optical member on an optical path on a light incident side with respect to the infrared light receiving section of the photoelectric conversion element is an infrared transmitting member having a maximum value of a light transmittance of 60% or more for light in the infrared range having a wavelength of 800 nm or longer and an average light transmittance of 10% or less for light in a wavelength range of 400 to 650 nm.

**2.** The optical sensor according to claim 1,

wherein the infrared transmitting member has a maximum value of a light transmittance of 60% or more for light in a range of the maximum absorption wavelength $\lambda_{max}$ of the quantum dot $\pm$ 50 nm and an average light transmittance of 10% or less for light in a wavelength range of 400 to 650 nm, and
the infrared light receiving section receives light of any wavelength in a range of the maximum absorption wavelength $\lambda_{max}$ of the quantum dot $\pm$ 50 nm.

**3.** The optical sensor according to claim 1 or 2,
wherein the infrared transmitting member has a wavelength having a light transmittance of 50% in a range of the maximum absorption wavelength $\lambda_{max}$ of the quantum dot - 200 nm or longer and the maximum absorption wavelength $\lambda_{max}$ of the quantum dot + 20 nm or shorter.

4. The optical sensor according to any one of claims 1 to 3,
wherein the infrared transmitting member satisfies Relational Expression (IR1):

$$(T^1/T^2) > 5.0 \qquad (IR1)$$

$T^1$ is a light transmittance of the infrared transmitting member for light having the maximum absorption wavelength $\lambda_{max}$ of the quantum dot, and
$T^2$ is a light transmittance of the infrared transmitting member for light having the maximum absorption wavelength $\lambda_{max}$ of the quantum dot $\times$ 0.8.

5. The optical sensor according to any one of claims 1 to 4,
wherein the infrared transmitting member includes a resin film containing a plurality of coloring materials.

6. The optical sensor according to claim 5,
wherein the resin film has a wavelength having a light transmittance of 50% in a range of the maximum absorption wavelength $\lambda_{max}$ of the quantum dot - 200 nm or longer and the maximum absorption wavelength $\lambda_{max}$ of the quantum dot + 20 nm or shorter.

7. The optical sensor according to any one of claims 1 to 6,
wherein the infrared transmitting member includes a dielectric multi-layer film.

8. The optical sensor according to claim 7,
wherein the dielectric multi-layer film has a plurality of transmission wavelength ranges having a maximum light transmittance of 90% or more.

9. The optical sensor according to any one of claims 1 to 8,
wherein the infrared transmitting member includes a microlens having a refractive index of 1.8 or more for light having the maximum absorption wavelength $\lambda_{max}$ of the quantum dot.

10. The optical sensor according to any one of claims 1 to 9,

wherein the photoelectric conversion element has another light receiving section that receives light having a wavelength different from a wavelength of the light received by the infrared light receiving section, and
the optical member has an optical filter including a plurality of pixels having different wavelengths of transmitted light.

11. The optical sensor according to claim 10,
wherein each pixel of the optical filter is compartmented by a partition wall.

12. The optical sensor according to claim 10 or 11,
wherein each of regions of the photoelectric conversion element that receives light transmitted through each pixel of the optical filter is compartmented by a partition wall or a groove.

13. The optical sensor according to any one of claims 10 to 12,
wherein the other light receiving section receives light on a shorter wavelength side than a wavelength of the light received by the infrared light receiving section.

14. The optical sensor according to any one of claims 10 to 13,
wherein pixels of the optical filter on an optical path on a light incident side of the other light receiving section have a wavelength having a light transmittance of 60% or more in a range of 400 nm or longer and the maximum absorption wavelength $\lambda_{max}$ of the quantum dot $\times$ 0.8 nm or shorter.

15. The optical sensor according to any one of claims 1 to 14, further comprising a light emitting device having an emission maximum in a range of the maximum absorption wavelength $\lambda_{max}$ of the quantum dot $\pm$ 50 nm.

16. A sensing device comprising the optical sensor according to any one of claims 1 to 15.

FIG. 1

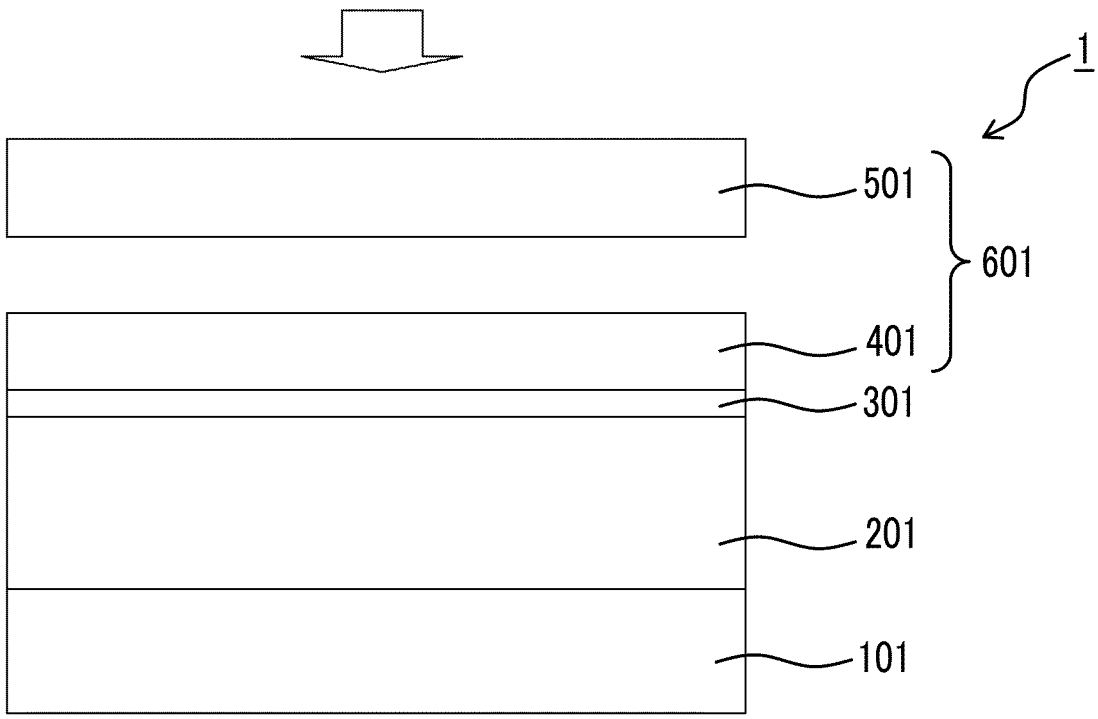


FIG. 2

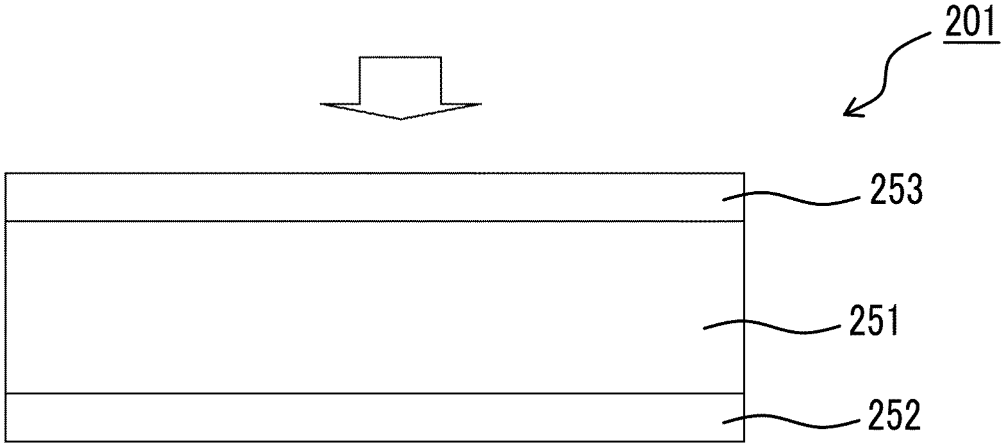

FIG. 3

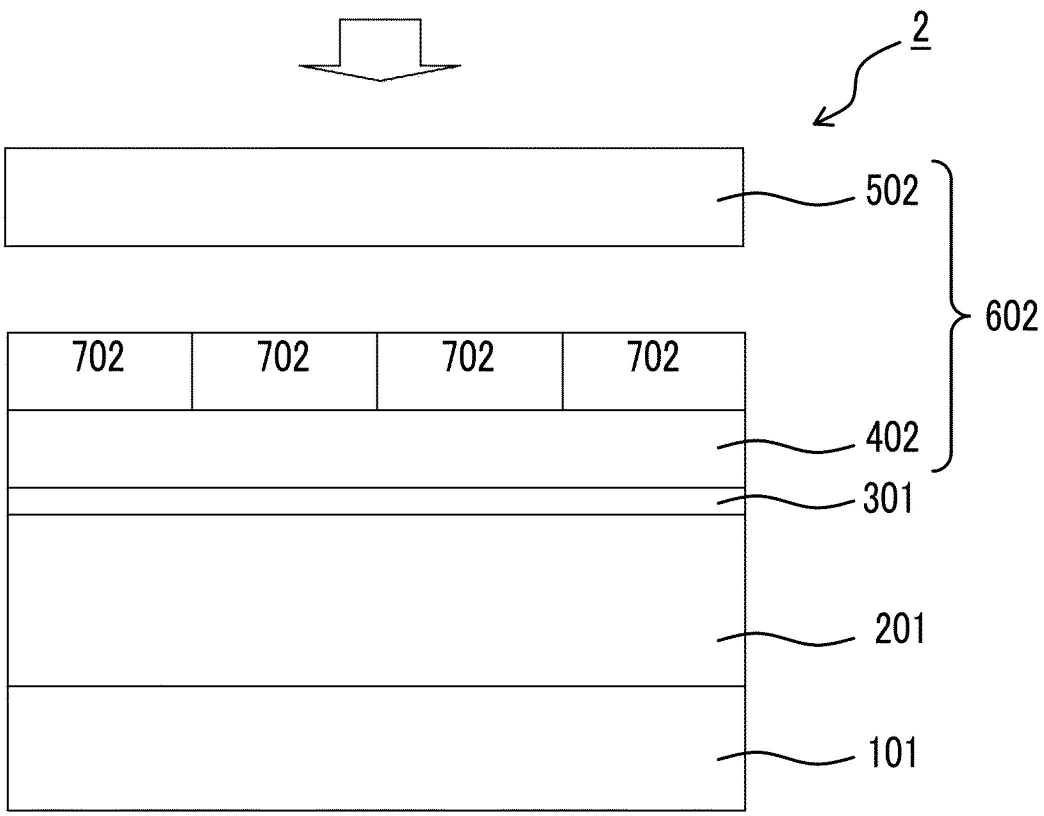

FIG. 4

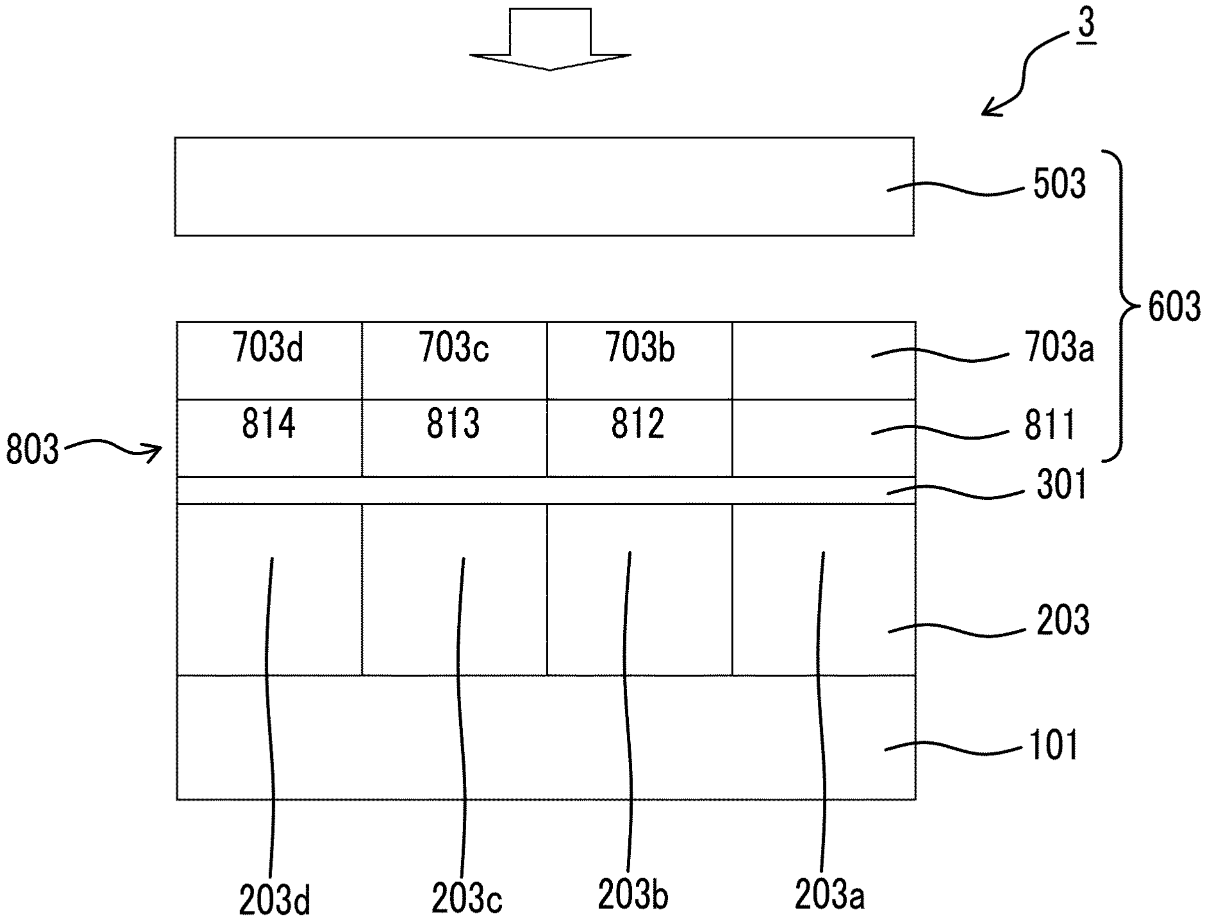
3
503
603
703d
703c
703b
703a
814
813
812
811
803
301
203
101
203d
203c
203b
203a

FIG. 5

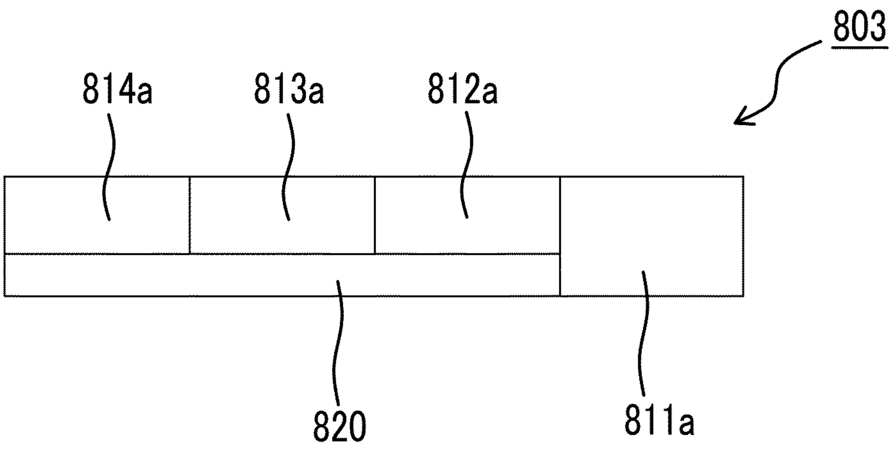
803
814a
813a
812a
820
811a

## INTERNATIONAL SEARCH REPORT

International application No.
PCT/JP2020/020440

A. CLASSIFICATION OF SUBJECT MATTER
H01L 31/0248(2006.01)i; G02B 5/20(2006.01)i; G02B 5/22(2006.01)i
FI: G02B5/22; G02B5/20; H01L31/08 K

According to International Patent Classification (IPC) or to both national classification and IPC

B. FIELDS SEARCHED

Minimum documentation searched (classification system followed by classification symbols)
H01L31/0248; G02B5/20; G02B5/22

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2017/150167 A1 (SONY CORP.) 08.09.2017 (2017-09-08) claims, paragraphs [0053], [0143], [0144], [0158], [0184] | 1-16 |
| Y | JP 2019-507899 A (3M INNOVATIVE PROPERTIES COMPANY) 22.03.2019 (2019-03-22) claims, paragraphs [0015], [0016], [0030] | 1-16 |
| Y | JP 2010-191424 A (SAMSUNG ELECTRONICS CO., LTD.) 02.09.2010 (2010-09-02) claims | 10-14 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 03 August 2020 (03.08.2020) | 18 August 2020 (18.08.2020) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2020/020440

| Patent Documents referred in the Report | Publication Date | Patent Family | Publication Date |
|---|---|---|---|
| WO 2017/150167 A1 | 08 Sep. 2017 | EP 3425900 A1<br>claims, paragraphs [0053], [0144], [0145], [0159], [0185]<br>CN 108702471 A<br>KR 10-2018-0117601 A | |
| JP 2019-507899 A | 22 Mar. 2019 | US 2019/0025481 A1<br>claims, paragraphs [0037], [0038] [0049]<br>WO 2017/127734 A1<br>EP 3405817 A1<br>TW 201738588 A<br>CN 108474882 A<br>KR 10-2018-0097757 A | |
| JP 2010-191424 A | 02 Sep. 2010 | US 2010/0208172 A1<br>claims<br>KR 10-2010-0093860 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2017150167 A
- WO 2015118720 A
- CN 1069009027
- WO 2012102395 A
- JP 2019008014 A
- JP 2018180023 A
- JP 2012247591 A
- JP 2011157478 A
- JP 2017201003 A
- JP 2017197719 A
- JP 2017171912 A
- JP 2017171913 A
- JP 2017171914 A
- JP 2017171915 A
- JP 2013054339 A
- JP 2014026228 A
- JP 2018062644 A
- JP 2018203798 A
- JP 2018062578 A
- JP 6432077 B
- JP 6432076 B
- JP 2018155881 A
- JP 2018111757 A
- JP 2018040835 A
- JP 2017197640 A
- JP 2016145282 A
- JP 2014085565 A
- JP 2014021139 A
- JP 2013209614 A
- JP 2013209435 A
- JP 2013181015 A
- JP 2013061622 A
- JP 2013032486 A
- JP 2012226110 A
- JP 2008074987 A
- JP 2008081565 A
- JP 2008074986 A
- JP 2008074985 A
- JP 2008050420 A
- JP 2008031281 A
- JP 48032765 B
- JP 6443711 B
- JP 2017201384 A
- JP 6248838 B
- WO 2012102399 A
- WO 2012117965 A
- JP 2012229344 A
- JP 2012158649 A
- JP 2011184493 A
- JP 2011145540 A
- JP 2009263614 A
- JP 2011068731 A
- WO 2015166873 A
- JP 2011208101 A
- JP 6065169 B
- WO 2016181987 A
- JP 2015176046 A
- WO 2016190162 A
- JP 2016074649 A
- JP 2017067963 A
- WO 2017135359 A
- JP 2017114956 A
- JP 6197940 B
- WO 2016120166 A
- JP 2009108267 A
- JP 2002194040 A
- JP 2015172004 A
- JP 2015172102 A
- JP 2008088426 A
- JP 2017031394 A
- JP 2017082029 A
- JP 2008528706 A
- JP 2012012399 A
- JP 2007092060 A
- WO 2018043564 A
- JP 2012077153 A
- JP 2006343631 A
- JP 2013195480 A
- JP 6081771 B
- JP 5733804 B
- JP 2016006476 A
- WO 2017119394 A
- JP 2017197437 A
- JP 2017025311 A
- WO 2016154782 A
- JP 5884953 B
- JP 6036689 B
- JP 5810604 B
- WO 2017213047 A
- JP 2018054760 A
- JP 2018040955 A
- JP 2018002773 A
- JP 2018041047 A
- JP 2017179131 A
- JP 2017141215 A
- JP 2017068120 A
- JP 6251530 B
- JP 2009145395 A